(19) Europäisches Patentamt / European Patent Office / Office européen des brevets

(11) **EP 4 310 885 A1**

(12) **EUROPEAN PATENT APPLICATION**

(43) Date of publication:
**24.01.2024 Bulletin 2024/04**

(21) Application number: **22186294.9**

(22) Date of filing: **21.07.2022**

(51) International Patent Classification (IPC):
**H01J 37/317** (2006.01) **H01J 37/28** (2006.01)
**H01J 37/26** (2006.01) **H01J 37/21** (2006.01)
**G03F 9/00** (2006.01)

(52) Cooperative Patent Classification (CPC):
**H01J 37/28; G03F 9/7003; H01J 37/21;**
**H01J 37/265;** H01J 2237/24578; H01J 2237/248

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **OOMS, Thomas, Adriaan**
**5500 AH Veldhoven (NL)**
• **VERGEER, Niels**
**5500 AH Veldhoven (NL)**

• **BOSCH, Niels, Johannes, Maria**
**5500 AH Veldhoven (NL)**
• **KUIPER, Vincent, Sylvester**
**5500 AH Veldhoven (NL)**
• **HEMPENIUS, Peter, Paul**
**San Jose, 95134 (US)**
• **STEENBRINK, Stijn, Wilem, Herman, Karel**
**5500 AH Veldhoven (NL)**
• **SLOT, Erwin**
**5500 AH Veldhoven (NL)**

(74) Representative: **ASML Netherlands B.V.**
**Corporate Intellectual Property**
**P.O. Box 324**
**5500 AH Veldhoven (NL)**

(54) **ELECTRON-OPTICAL APPARATUS AND METHOD OF OBTAINING TOPOGRAPHICAL INFORMATION ABOUT A SAMPLE SURFACE**

(57) This discloses apparatus and methods for obtaining topographical information about a sample surface. In one arrangement, a sensing system comprises a group of proximal sensors for measuring positions of respective portions of a sample surface, and a distal sensor positioned more remotely from paths of sub-beams of a multibeam than the proximal sensors. The distal sensor measures a position of a portion of the sample surface relative to the distal sensor. A control system controls a charged particle device to process the sample surface in a multibeam processable area using the multibeam. A stage causes the multibeam processable area to move along a processing path in a reference frame of the sample. The sensing system uses at least the distal sensor to obtain topographical information about the sample surface in a selected portion of the processing path before the multibeam processable area reaches the selected portion of the processing path.

Fig. 10

**Description**

FIELD

The present disclosure relates to apparatus and methods for obtaining topographical information about a sample surface, particularly for use in the context of assessing samples using a multibeam of charged particles.

BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the assessment for example inspection and/or measurement of a surface of a substrate, or other object/material, is an important process during and/or after its manufacture.

Assessment tools, which herein are referred to as assessment systems, are known that use a charged particle beam to assess objects, which may be referred to as samples, for example to detect pattern defects. These systems typically use electron microscopy techniques, such as a scanning electron microscope (SEM). In a SEM, a primary electron beam of electrons at a relatively high energy is targeted with a final deceleration step to land on a sample at a relatively low landing energy. The beam of electrons is focused as a probing spot on the sample. The interactions between the material structure at the probing spot and the landing electrons from the beam of electrons cause signal electrons to come from the surface for example as signal electrons, such as secondary electrons, backscattered electrons or Auger electrons which more generally may be referred to as signal particles. The signal electrons may be emitted from the material structure of the sample. By scanning the primary electron beam as the probing spot over the sample surface, signal electrons can be emitted across the surface of the sample. By collecting these emitted signal electrons from the sample surface, a pattern inspection system may obtain an image representing characteristics of the material structure of the surface of the sample.

Higher throughput in assessment systems can be achieved by increasing the number of beams that are simultaneously incident on the sample. Assessment systems configured to operate in this way may be referred to as multibeam systems and can simultaneously project very large numbers of individual beams onto the sample in parallel over a relatively large area on the sample surface, which may be referred to as the Field of View (FoV). Having a large FoV enables high throughput. It has proven challenging, however, to focus beams accurately over such large FoVs due to non-uniform topographies of the sample surface. It is possible to correct for these by obtaining topographical maps of the sample surface but measurements to obtain such maps are time consuming and can be inaccurate, for example where surface topography changes over time and/or due to inaccuracies in stage positioning.

SUMMARY

It is an object of the present disclosure to provide apparatus and methods that support improved control of focus in arrangements that assess samples using multibeams of charged particles.

According to an aspect of the invention, there is provided an electron-optical apparatus, comprising: a stage configured to support a sample having a sample surface; a charged particle device configured to project a multibeam towards the sample along a multibeam path that intersects the sample in a multibeam processable area, the multibeam comprising a plurality of sub-beams of charged particles having paths within the multibeam path desirably arranged in a grid; a sensing system comprising: a group of proximal sensors positioned proximate to the paths of the plurality of sub-beams, each proximal sensor configured to measure a position of a respective portion of the sample surface relative to that proximal sensor, and one or more distal sensors, the or each distal sensor positioned more remotely from the paths of the sub-beams than the proximal sensors, the or each distal sensor being configured to measure a position of a respective portion of the sample surface relative to the distal sensor; and a control system configured to: control the charged particle device to process the sample surface in the multibeam processable area using the multibeam, desirably to assess the sample surface using the multibeam; control the stage to cause the multibeam processable area to move along a processing path in a reference frame of the sample; and control the sensing system to use at least the one or more distal sensors to obtain topographical information about the sample surface in a selected portion of the processing path before the multibeam processable area reaches the selected portion of the processing path.

According to an aspect of the invention, there is provided an electron-optical apparatus, comprising: a stage configured to support a sample having a sample surface; a charged particle device configured to project a multibeam towards the sample along a multibeam path that intersects the sample in a multibeam processable area to process the sample with the multibeam, the multibeam comprising a plurality of sub-beams of charged particles having paths within the multibeam path desirably arranged in a grid; and a sensing system comprising a plurality of sensors, each sensor being configured to measure a position relative to the sensor of a respective portion of the sample surface outside of the multibeam processable area, wherein the plurality of sensors comprises at least a first sensor, a second sensor, and a third sensor positioned such that, in a projection of positions of the sensors and the multibeam processable area onto a plane parallel to the sample, a vector joining positions of the first sensor and the second sensor is substantially equal or opposite to a vector joining a position of the third sensor to a center of the multibeam processable area.

According to an aspect of the invention, there is provided a method of obtaining topographical information about a sample surface, comprising: projecting a multibeam of charged particles towards a sample along a multibeam path that intersects the sample in a multibeam processable area to process the sample surface in the multibeam processable area, the multibeam comprising a plurality of sub-beams having paths within the multibeam path desirably arranged in a grid; using a group of proximal sensors positioned proximate to the paths of the plurality of sub-beams to measure positions of respective portions of the sample surface relative to the proximal sensors; using one or more distal sensors positioned more remotely from the paths of the sub-beams than the proximal sensors to measure one or more respective portions of the sample surface relative to the one or more distal sensors; providing relative movement between the multibeam processable area and the sample such that the multibeam processable area moves along a processing path in a reference frame of the sample; and using at least the one or more distal sensors to obtain topographical information about the sample surface in a selected portion of the processing path before the multibeam processable area reaches the selected portion of the processing path.

According to an aspect of the invention, there is provided a method of obtaining topographical information about a sample surface, comprising: projecting a multibeam of charged particles towards the sample along a multibeam path that intersects the sample in a multibeam processable area to process the sample with the multibeam, the multibeam comprising a plurality of sub-beams having paths within the multibeam path desirably arranged in a grid; obtaining topographical information about the sample surface using a plurality of sensors to measure positions relative to the sensors of respective portions of the sample surface outside of the multibeam processable area, wherein the plurality of sensors comprises at least a first sensor, a second sensor, and a third sensor positioned such that, in a projection of positions of the sensors and the multibeam processable area onto a plane parallel to the sample, a vector joining positions of the first sensor and the second sensor is substantially equal or opposite to a vector joining a position of the third sensor to a center of the multibeam processable area.

According to an aspect of the invention, there is provided a computer program comprising instructions interpretable by a computer that controls an assessment apparatus, the computer program comprising instructions to perform a method according any the other aspect of the invention herein.

BRIEF DESCRIPTION OF FIGURES

The above and other aspects of the present disclosure will become more apparent from the description of exemplary embodiments, taken in conjunction with the accompanying drawings.

**FIG. 1** is a schematic diagram illustrating an exemplary charged particle beam inspection apparatus.

**FIG. 2** is a schematic diagram illustrating an exemplary multi-beam apparatus that is part of the exemplary charged particle beam inspection apparatus of **FIG. 1.**

**FIG. 3** is a schematic diagram of an exemplary electron-optical column comprising a condenser lens array, an objective lens array and a charged particle detector array.

**FIG. 4** is a schematic cross-sectional view of a portion of an objective lens array of an exemplary arrangement for example with a detector array.

**FIG. 5** is bottom view of the portion of the objective lens array of **FIG. 4.**

**FIG. 6** is a bottom view of a modified version of the portion of the objective lens array of **FIG. 4.**

**FIG. 7** is a schematic diagram of an exemplary electron-optical device comprising a beam separator.

**FIG. 8** is a schematic bottom view of a beam grid and sensors.

**FIG. 9** is a schematic side view of a portion of a sample down-beam of an arrangement of the type shown in **FIG. 8.**

**FIG. 10** shows a projection onto a plane of positions of a multibeam processable area and sensors comprising a group of proximal sensors and a distal sensor which may be configured to operate as a forward sensor.

**FIG. 11** shows a projection onto a plane of positions of a multibeam processable area and sensors comprising a group of proximal sensors, a distal sensor which may be configured to operate as a forward sensor, and a distal sensor which may be configured to operate as a side sensor.

**FIG. 12** shows a projection onto a plane of positions of a multibeam processable area and sensors comprising a group of proximal sensors, a distal sensor which may be configured to operate as a forward sensor, a distal sensor which may be configured to operate as a rear sensor, and two distal sensors which may be configured to operate as side sensors.

**FIG. 13** schematically depicts an arrangement of the type depicted in **FIG. 11** beginning processing of a sample along a processing path comprising parallel and offset routes.

**FIG. 14** schematically depicts a later stage of the processing of the sample shown in **FIG. 13.**

**FIG. 15** schematically depicts how topographical information about regions of the sample surface can be obtained progressively and on the fly (or 'on-the-fly') as the multibeam processable area moves relative to the sample surface.

**FIG. 16** depicts the progressive obtaining of the topographical information at a later point along the processing path relative to **FIG. 15.**

**FIG. 17** depicts the progressive obtaining of the topographical information at a still later point along the processing path relative to **FIG. 15** and **16.**

**FIG. 18** is a schematic side sectional view of a multibeam grid path and sample showing in exaggerated form how certain types of spatial deformation for an embodiment of sensors can lead to errors in focus.

**FIG. 19** shows a projection onto a plane of positions of a multibeam processable area and sensors to show vector relationships between positions of a first sensor, second sensor, third sensor and a center of the multibeam processable area.

**FIG. 20** shows the projection of **FIG. 19** with further vector relationships.

**FIG. 21** is a flow chart depicting a methodology for generating and using a correction value to determine topographical information and process a sample.

DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than $1/1000^{th}$ of a human hair. Thus, it is not surprising that semiconductor IC manufacturing is a complex and time-consuming process, with hundreds of individual steps. Errors in even one step have the potential to dramatically affect the functioning of the final product. Even a single defect can cause device failure in certain situations. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection systems (such as a Scanning Electron Microscope ('SEM')) is essential for maintaining high yield and low cost.

A SEM comprises a scanning device and a detector apparatus or module. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical device or column. The primary electrons interact with the sample and generate signal particles such as secondary electrons. The detection apparatus captures the signal particles (e.g. secondary electrons) from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

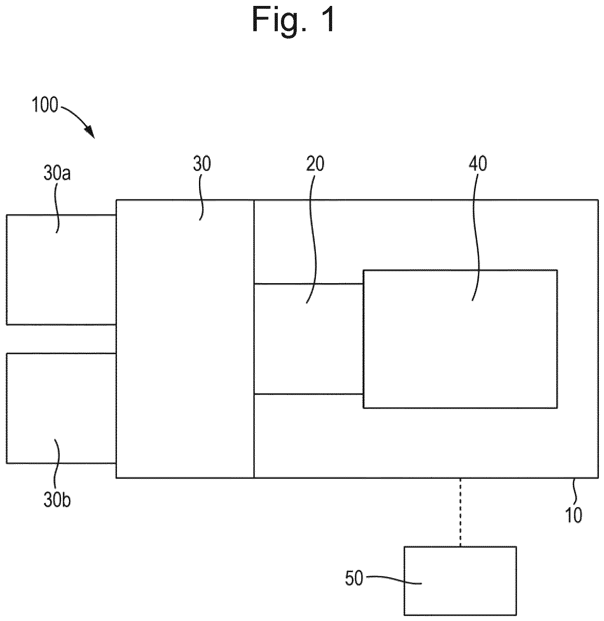

Reference is now made to **FIG. 1**, which is a schematic diagram illustrating an exemplary charged particle beam inspection apparatus 100, which may also be referred to as a charged particle beam assessment system or simply assessment system. The charged particle beam inspection apparatus 100 of **FIG. 1** includes a main chamber 10, a load lock chamber 20, an electron beam apparatus 40, an equipment front end module (EFEM) 30 and a controller 50. The controller may be distributed between different components of the assessment system, including for example in the electron beam apparatus 40. Electron beam apparatus 40 is located within main chamber 10.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas particles in main chamber 10 so that the pressure in around the sample reaches a second pressure lower than the first pressure. After reaching the second pressure, the sample is transported to the electron beam apparatus by which it may be inspected. An electron beam apparatus 40 may comprise a multi-beam electron-optical apparatus.

Controller 50 is signally, for example electronically connected to electron beam apparatus 40, for example as distributed components of the controller 50. Controller 50 may be a processor (such as a computer) configured to control the charged particle beam inspection apparatus 100. Controller 50 may also include a processing circuitry configured to execute various signal and image processing functions. While controller 50 is shown in **FIG. 1** as being outside of the structure that includes main chamber 10, load lock chamber 20, and EFEM 30, it is appreciated that controller 50 may be part of the structure. The controller 50 may be located in one of the component elements of the charged particle beam inspection apparatus or it can be distributed over at least two of the component elements. While the present disclosure provides examples of main chamber 10 housing an electron beam inspection apparatus, it should be noted that aspects of the disclosure in their broadest sense are not limited to a chamber housing an electron beam inspection apparatus. Rather, it is appreciated that the foregoing principles may also be applied to other systems and other arrangements of apparatus, that operate under the second pressure.

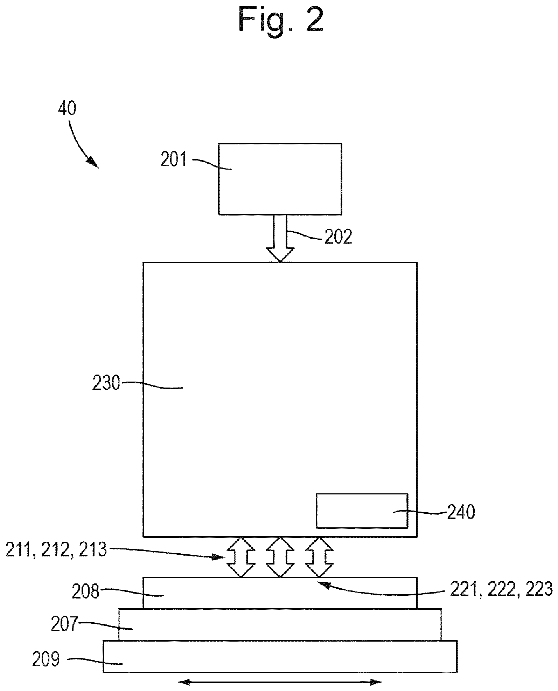

Reference is now made to **FIG. 2**, which is a schematic diagram illustrating an exemplary charged particle beam apparatus 40. The electron beam apparatus 40 may be provided as part of the exemplary charged particle beam inspection system 100 of **FIG. 1.** The electron beam apparatus 40 includes an electron source 201 and an assessment apparatus. The assessment apparatus comprises a charged particle device 230. The charged particle device 230 may comprise or consist of a projection apparatus for directing a primary charged particle beam 202 towards a sample 208. The electron source 201 and the charged particle device 230 may together be referred to as an illumination apparatus for generating a primary charged particle beam 202. The assessment apparatus comprises a sample support that supports a sample 208. The sample support in this example comprises a sample holder 207. The sample holder 207 holds the sample 208 (e.g., a substrate or a mask) for assessment. The sample holder 207 is supported by a motorized or actuated stage 209. The electron beam apparatus 40 further comprises a detector 240. The detector 240 detects signal charged particles (e.g., electrons) from the sample 208. The detector 240 generates detection signals on detection of the signal charged particles.

Electron source 201 may comprise a cathode (not shown) and an extractor or anode (not shown). During operation, electron source 201 is configured to emit electrons as primary electrons from the cathode. The primary electrons are extracted or accelerated by the extractor and/or the anode to form the primary electron beam 202.

Charged particle device 230 is configured to convert primary electron beam 202 into a plurality of charged particle beams 211, 212, 213 and to direct each beam onto the sample 208. Although three beams are illustrated for simplicity, there may be many tens, many hundreds, many thousands, many tens of thousands, or even hundreds of thousands (or more) of beams. The beams may be referred to as beamlets or sub-beams. The plurality of charged particle beams may be referred to collectively as a multi-beam or beam grid. A beam grid with so many beams (e.g. more than a thousand beams) may have a field of view of e.g. more than 0.5mm, for example in the range of 0.5 to 30mm or 1 to 30 mm, for example in the range of 0.5 to 15mm.

Controller 50 (for example control system comprising distributed controllers) may be connected to various parts of charged particle beam inspection apparatus 100 of **FIG. 1**, such as electron source 201, electron detection device 240, charged particle device 230, and motorized stage 209 (or actuated stage). Controller 50 may perform various image and signal processing functions. Controller 50 may also generate various control signals to govern operations of the charged particle beam inspection apparatus 100, including operations of the electron beam tool 40.

Charged particle device 230 may be configured to focus beams 211, 212, and 213 onto a sample 208 for inspection and may form three probe spots 221, 222, and 223 on the surface of sample 208. Charged particle device 230 may be configured to deflect primary beams 211, 212, and 213 to scan probe spots 221, 222, and 223 across individual scanning areas in a section of the surface of sample 208. In response to incidence of primary beams 211, 212, and 213 on probe spots 221, 222, and 223 on sample 208, electrons are generated from the sample 208 which include secondary electrons and backscattered electrons which may be referred to as signal charged particles or signal particles. The secondary electrons typically have electron energy as large as fifty electron volts ($\leq$50 eV) and backscattered electrons typically have electron energy between fifty electron volts (50 eV) and the landing energy of primary beams 211, 212, and 213.

The detector 240 may send the detection signals generated in the detector 240, for example as an imaging or detection signal, to controller 50 or a signal processing system (not shown, which may be part of the controller 50), e.g. to construct images of the corresponding scanned areas of sample 208. The detector 240 may be incorporated at least partly into the charged particle device 230 or may be separate therefrom, for example with a secondary optical column being provided to direct signal charged particles, e.g. secondary electrons and/or backscattered electrons, to the detector 240.

The controller 50 may comprise an image processing system that includes an image acquirer (not shown) and a storage device (not shown). For example, the controller may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive the detection signal from the detector 240, may process the data comprised in the signal and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample 208 based on an imaging signal received from the detector 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons, or more generally the signal charged particles. A part of the controller for such a function may be comprised in or proximate to the detector. The electron distribution data, collected during a detection time window, can be used in combination with corresponding scan path data of each of primary beams 211, 212, and 213 incident on the sample surface to reconstruct images of the sample structures under inspection. The reconstructed images can be used to reveal various features of the internal or external structures of sample 208. The reconstructed images can thereby be used to reveal any defects that may exist in and/or on the sample.

The controller 50 may control the actuated stage 209 to move sample 208 during inspection of sample 208, for example to provide a scanning motion of the stage relative to the paths of the primary beams. The controller 50 may enable the actuated stage 209 to move sample 208 in a direction such as part of the scanning motion of the stage, desirably continuously, for example at a constant speed, at least during sample inspection. The controller 50 may control movement of the actuated stage 209 so that it changes the speed of the movement of the sample 208 dependent on various parameters. For example, the controller may control the stage speed (including its direction) depending on the characteristics of the inspection steps and/or scans of the scanning process for example as disclosed in EPA 21171877.0 filed 3 May 2021 which is hereby incorporated by reference in so far as the combined stepping and scanning strategy at least of the stage. In controlling the actuated stage, actuation of the stage and thus the sample may enable the sample to be positioned, for example dynamically, relative to the paths of the primary beams.

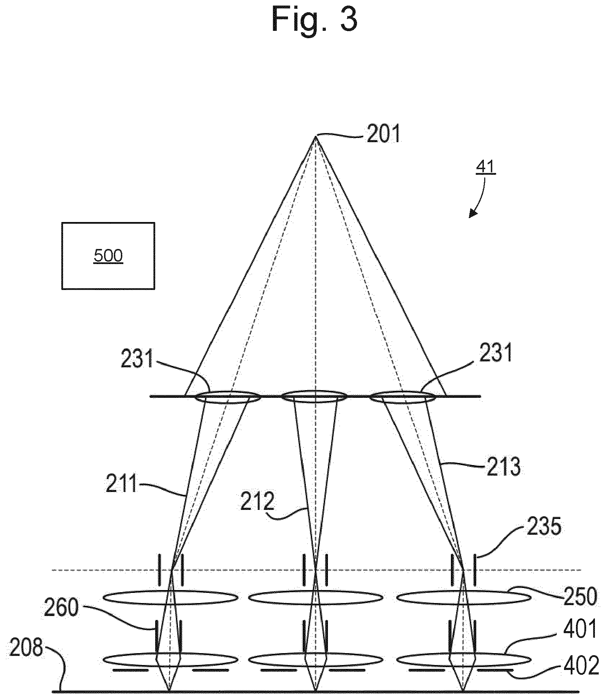

**FIG. 3** is a schematic diagram of an exemplary charged particle device 41 for use in an assessment apparatus. The charged particle device 41 may be referred to as an electron-optical column or electron-optical device. For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged particle devices such as those discussed herein, it will be understood that lens arrays will typically operate electrostatically and so may not require any physical elements adopting a biconvex shape. As described below, lens arrays may instead comprise multiple plates with apertures. Each plate with apertures may be referred to as an electrode. The electrodes may be provided in series along a path of a beam grid of a plurality of charged particle beams (which may also be referred to as sub-beams). The electrodes are thus also in series along paths of charged particle beams of the beam grid.

Electron source 201 directs electrons toward an array of condenser lenses 231 forming part of charged particle device 230. The electron source 201 is desirably a high brightness thermal field emitter with a good compromise between brightness and total emission current. There may be many tens, many hundreds or many thousands or even tens of thousands of condenser lenses 231. Condenser lenses of array 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The condenser lens array may take the form of at least two, preferably three, plates, acting as electrodes, with apertures in each plate aligned with apertures in other plates to define paths for charged particle beams through the plates. At least two of the plates are maintained during operation at different potentials to achieve the desired lensing effect. Between the plates of the condenser lens array are electrically insulating plates, for example made of an insulating material such as ceramic or glass, with one or more apertures for the charged particle beams. Additionally or alternatively, one or more of the plates may feature apertures that each have their own electrode, for example with an array of electrodes around their perimeter or arranged in groups of apertures having a common electrode. In a variant, one or more of the plates may comprise multiple portions or strips with multiple apertures. In a further alternative arrangement, a macro collimator is provided instead of the condenser lens array. The macro collimator may act on the beam from the source 201 before the beam has been split into a multi-beam. The macro collimator may be implemented magnetically, electrostatically, or magnetically and electrostatically.

In some embodiments, the condenser lens array is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens in the array directs electrons into a respective beam 211, 212, 213 which is focused at a respective intermediate focus 233. A collimator or an array of collimators may be positioned to operate on the respective intermediate focuses 233. The collimators may take the form of deflectors 235 provided at the intermediate focuses 233. Deflectors 235 are configured to bend a respective beam 211, 212, 213 by an amount effective to ensure that the principal ray (which may also be referred to as the beam axis) is incident on the sample 208 substantially normally (i.e. at substantially 90° to the nominal surface of the sample). Note that in an arrangement with a macro condenser lens, the condenser lens may collimate or contribute to the collimation of the source beam or, in an embodiment, a plurality of beams.

An objective lens array 401 is provided down-beam from the deflectors 235. The objective lens array 501 comprises an objective lens for each beam 211, 212, 213. The objective lens array 401 projects the beams 211, 212, 213 onto the sample 208. The objective lens array 401 may comprise two or more, preferably at least three, plate electrode arrays connected to respective potential sources.

Optionally, a control lens array 250 is provided between the deflectors 235 and the objective lens array 401. The control lens array 250 comprises a control lens for each beam 211, 212, 213. The control lens array 250 provides additional degrees of freedom for controlling properties of the beams 211, 212, 213. The control lens array 250 may comprise two or more, preferably at least three, plate electrode arrays connected to respective potential sources. A function of control lens array 250 is to optimize the beam opening angle with respect to the demagnification of the beam and/or to control the beam energy delivered to the objective lenses, each of which directs a respective beam 211, 212, 213 onto the sample 208. In an embodiment the control lens array may be considered to be part of the objective lens, for example in being additional plates associated with the objective lens array.

Optionally an array of scan deflectors 260 is provided between the control lens array 250 and the objective lens array 401. The array of scan deflectors 260 comprises a scan deflector for each beam 211, 212, 213. Each scan deflector is configured to deflect a respective beam 211, 212, 213 in one or two directions to scan the beam across the sample 208 in one or two directions. Alternatively, a macro scan deflector may be provided to scan the charged particle beams over the sample 208. The macro scan deflector may be provided up-beam of the control lens array 250. In an embodiment such a macro scan deflector may operate on the source beam and may be present with a macro condenser lens.

A detector module 402 may comprise a detector. The detector module 402 may be provided within the objective lenses or between the objective lenses and the sample 208 to detect signal electrons/particles from the sample 208. An exemplary construction of such a detector module 402 is described below. Note that the detector additionally or alternatively may have detector elements upbeam along the primary beam path of the objective lens array 401 or even the control lens array 250. The detector module may be an array of detector elements (e.g. a detector array). Each element may be associated with an individual beam, for example positioned to detect signal particles generated by the individual beam.

The charged particle device 41 of **FIG. 3** may be configured to control the landing energy of electrons on the sample 208 by varying potentials applied to the electrodes of the control lenses and the objective lenses. The control lenses and objective lenses work together and may be referred to as an objective lens assembly. The landing energy can be selected to increase emission and detection of secondary electrons (or more generally the signal particles) dependent on the nature of the sample being processed such as assessed (for example inspected or measured). The detector module may be comprised in the objective lens assembly

The objective lenses can be configured to demagnify the electron beam by a factor greater than 10, desirably in the range of 50 to 100 or more. The objective lenses may comprise three electrodes, for example the objective lenses may comprise a middle electrode, a lower electrode and an upper electrode. The upper electrode may be omitted. An objective lens having only two electrodes can have lower aberration than an objective lens having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beams.

In some embodiments, the objective lens array assembly comprises a detector having a detector module 402 downbeam of at least one electrode of the objective lens array 401. The detector module 402 may comprise or even take the form of a detector array. In an embodiment, at least a portion of the detector is adjacent to and/or integrated with the objective lens array 401. For example, the detector module 402 may be implemented by integrating a CMOS chip detector into a bottom electrode of the objective lens array 401. Integration of a detector module 402 into the objective lens array may replace or be in addition to a secondary column. The CMOS chip is preferably orientated to face the sample (because of the small distance between sample and the bottom of the electron-optical device. The distance between the between sample and the bottom of the electron-optical device may for example be in the range of 10 to 400 micron, desirably in the range of 50 to 200 micron, optionally about 100 micron). It is noted that even in situations in which the detector is up-beam of the most down-beam electron-optical element of the charged particle device, there may be a close, e.g. of similar distance, separation between the most down-beam electron-optical element and the sample (e.g., $100\mu m$). In an embodiment, electrodes to capture the signal charged particles are formed in the top metal layer of the CMOS device. The electrodes can be formed in other layers of the substrate, e.g. of the CMOS chip. Power and control signals of the CMOS may be connected to the CMOS by through-silicon vias. For robustness, preferably the bottom electrode consists of two elements: the CMOS chip and a passive Si plate with holes. The plate shields the CMOS from high E-fields.

In an embodiment, a single electrode surrounds at least some of the apertures. In an arrangement a single electrode is assigned for example around each aperture. In another embodiment, a plurality of electrode elements are provided around each aperture. The signal charged particles captured by the electrode elements surrounding one aperture may be combined into a single detection signal or used to generate independent detection signals. The electrode elements may be divided radially (i.e., to form a plurality of concentric annuluses), angularly (i.e., to form a plurality of sector-like pieces), both radially and angularly or in any other convenient manner.

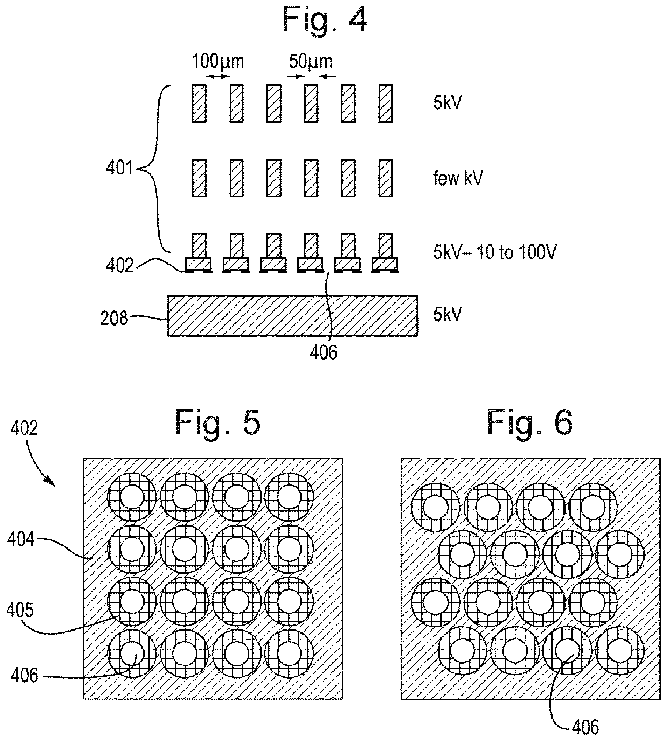

An exemplary embodiment of a detector integrated into an objective lens array 401 is shown in **FIG. 4**, which illustrates a portion of an objective lens array 401 in schematic cross section. In this embodiment, the detector comprises a detector module 402 comprising a plurality (e.g., an array) of detector elements 405 (labelled in **FIG. 5**) (e.g., sensor elements such as capture electrodes) preferably as an array of detector elements (i.e. a plurality of detector elements in a pattern or arrangement preferably over a two dimensional surface). In this embodiment, the detector module 402 is provided on an output side of the objective lens array. The output side is the output side of the objective lens array 401. **FIG. 5** is a bottom view of detector module 402 which comprises a substrate 404 on which are provided a plurality of detector elements 405 (e.g. capture electrodes) each surrounding a beam aperture 406. The beam apertures 406 may be formed by etching through substrate 404. In the arrangement shown in **FIG. 5**, the beam apertures 406 are shown in a rectangular array. The beam apertures 406 can also be differently arranged, e.g. in a hexagonal close packed array as depicted in **FIG. 6.**

The integrated detector module 402 described above is particularly advantageous when used with a tool having tunable landing energy because signal particle e.g. secondary electron, capture can be optimized for a range of landing energies. A detector module comprising an array of detector elements (or capture electrodes - the detector module even being in the form of an array) can also be integrated into other electrode arrays, not only the lowest electrode array. Further details and alternative arrangements of a detector module integrated into an objective lens can be found in EP Application Number 20184160.8, which document is hereby incorporated by reference.

An electric power source may be provided to apply respective potentials to electrodes of the control lenses of the control lens array 250 and the objective lenses of the objective lens array 401.

In an embodiment, an array of charged particle devices (or device array) is provided. The array may comprise a plurality of any of the charged particle devices (e.g., electron-optical columns) described herein. Each of the charged particle devices in the array focuses respective pluralities of charged particle beams onto different regions of the same sample 208. Each charged particle device in the array may derive a respective plurality of charged particle beams from a different respective source 201. Each respective source 201 may be one source in a plurality of sources 201. At least a subset of the plurality of sources 201 may be provided as a source array. The source array may comprise a plurality of emitters on a common substrate. The focusing of pluralities of charged particle beams from different charged particle devices simultaneously onto different regions of the same sample allows an increased area of the sample 208 exposed to charged particle beams simultaneously. Therefore, an increased area of the sample may be assessed (or more generically processed) simultaneously. The charged particle devices in the array may be arranged adjacent to each other so as to project the respective pluralities of beams onto adjacent regions of the sample 208. Any number of charged particle devices may be used in the array. Preferably, the number of charged particle devices is in the range of from 9 to 200. Each charged particle device in the array may be configured in any of the ways described herein when referring to a single charged particle device, electron-optical device or system or column. Alternatively or additionally, one or more of the charged particle device in the array may be configured to project a single beam.

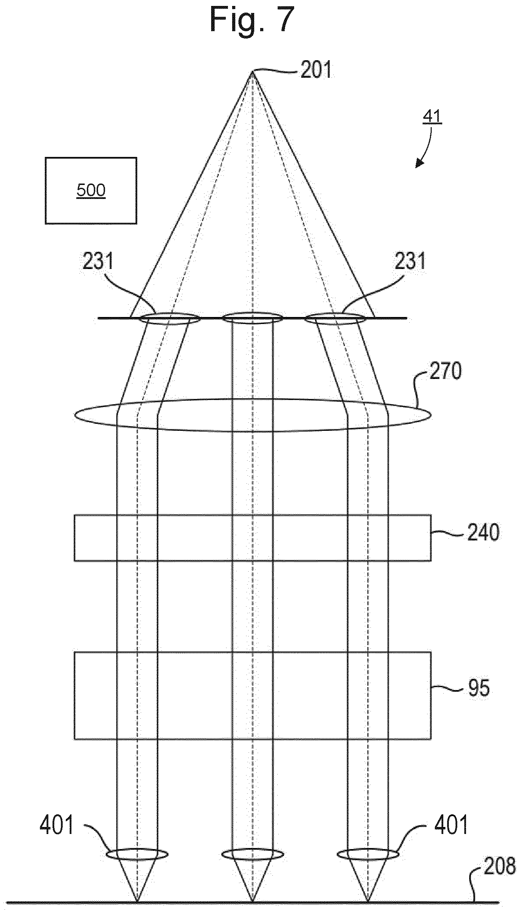

FIG. 7 schematically depicts a further example of a charged particle device 41. Features that are the same as those described above are given the same reference numerals. For conciseness, such features are not described in detail with reference to FIG. 7. For example, the source 201, the condenser lenses 231, the objective lens array 401 and the sample 208 may be as described above. In this example, a macro collimator 270 (for example as magnetic and/or electrostatic lens) is provided instead of a deflector array of the type described above with reference to FIG. 3. In other embodiments, a deflector array may be used additionally or alternatively to collimate the beams. In an arrangement the condenser lenses 231 may comprise a single plate defining a beam limiting aperture array in which are defined a plurality of apertures with one or more associated macro electrodes with a single aperture. Such a beam limiting aperture array and an associated macro electrode may also form a condenser lens array to focus the generated beams in an intermediate focus which desirably corresponds to the position of the collimator 270.

As described above, in some embodiments a detector may be provided between the objective lens array 401 and the sample 208. The detector may face the sample 208. Alternatively, as shown in FIG. 7, the detector 240 may be implemented such that the objective lens array 401 is between the detector 240 and the sample 208.

In an embodiment a deflector array 95 is provided between the detector 240 and the objective lens array 401. In an embodiment the deflector array 95 comprises a Wien filter array so that deflector array may be referred to as a beam separator. The deflector array 95 is configured to provide a magnetic field and an electrostatic field. The electrostatic and magnetic fields operate together to separate the charged particles projected to the sample 208 relative to the signal particles, e.g. secondary electrons, from the sample 208. Charged particles projected towards the sample 208 are directed to the sample by the filter. The operation of the fields directs the signal particles from the sample towards the detector 240.

In an embodiment the detector 240 is configured to detect signal particles by reference to the energy of the charged particle, i.e. dependent on a band gap, such a semiconductor based type of detector. Such a detector 240 may be called an indirect current detector. The signal particles (e.g. secondary electrons) from the sample 208 gain energy from the fields between the electrodes. The secondary electrons have sufficient energy once they reach the detector 240. In a different arrangement the detector 240 may be an electron to photon converter such as a scintillator array, for example of fluorescing strip between the beams that are positioned up beam along the primary beam path with respect to the Wien filter. Primary beams passing through the Wien filter array (of magnetic and electrostatic strips orthogonal to the primary beam path) have paths upbeam and downbeam of the Wien filter array that are substantially parallel, whereas signal electrons from the sample are directed by the Wien filter array towards the scintillator array. The electron to photon converter may be photonically coupled to a photon to electron converter to convert any photons generated in and emitted by the electron to photon converter. The photon to electron converter may be electrically connected to electronic circuitry to process a detection signal. In different embodiments the photon to electron converter may be within or external to the charged particle device. In an embodiment photon coupling may be by via a photon transport unit (e.g., an array of optical fibers) to a remote optical detector which generates a detection signal on detection of a photon.

Projecting a multibeam comprising a plurality of sub-beams of charged particles onto a sample increases throughput relative to a single beam but makes focus control more challenging especially with an increased field of view, for example a field of view of as much as 1mm, 5 mm, 10mm, 15mm or even 20mm. The quality of focus of each sub-beam on the sample surface is determined by the position of the focal plane of the sub-beam relative to the position on the sample surface on which the sub-beam is incident. If the position of the focal plane, for example of a beam of the multi-beam, is within an acceptable range of a corresponding portion of the sample surface, the quality of focus, for example of the beam, will be acceptable. Controlling the position of the focal plane for each sub-beam relative to the sample surface is challenging because of the typically nonplanar topography of the sample surface and the relatively large size of the area of intersection, between a multibeam path and the sample for example of the different beams of the multibeam (or grid). The area of intersection may be referred to as a multibeam processable area for example of the beam grid. The relatively large size of the area of intersection may be because of the size of the field of view of the multibeam at the surface of the sample.

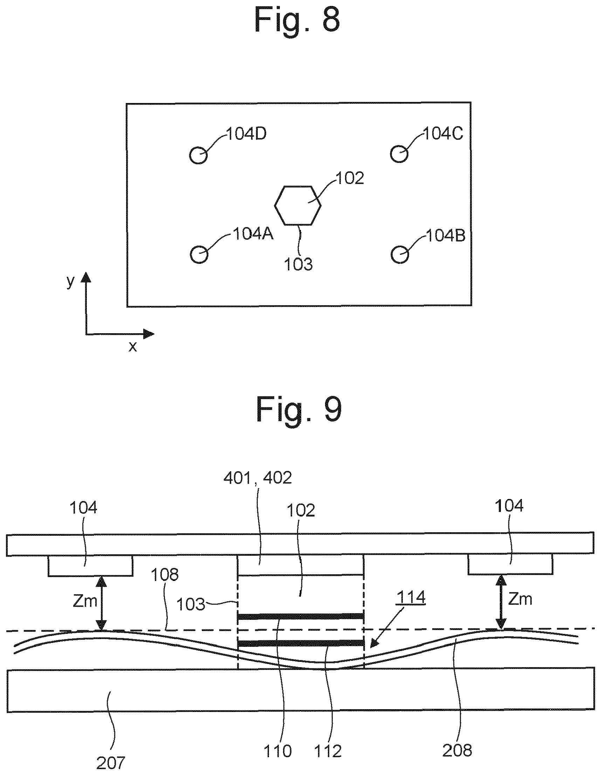

It is possible to obtain information about the topography of the sample surface using sensors that measure distances to respective portions of the sample surface. **FIG. 8** is a schematic bottom view (looking in an up-beam direction) of a charged particle device showing a multibeam 102 comprising a plurality of charged particle sub-beams and sensors 104A-D positioned for example outside of (or remote from) a path of the multibeam 102, i.e. the multibeam during operation. The path of the multibeam 102 may be referred to as the multibeam path 103, which defines a common path for all the sub-beams of the multibeam. Although an ideal representation of the multibeam path may be along a central path of the multibeam path towards the sample, the multi-beam path may also define the outermost extent of the multi-beam. For example the multi-beam path 103 may define a most distal (or radially outermost) limit of the multibeam 102. All of the sub-beams of the multibeam 102 are contained with the multibeam path 103. The different sub-beams may be referred to as having a respective sub-beam path. Such a sub-beam path is within the multi-beam path. The multibeam path 103 thus defines a multibeam volume between the charged particle device and the sample 208 that contains the sub-beams and the sub-beam paths. No sub-beams are present outside the multibeam path 103. In this example, four sensors 104A-D are provided distal relative to (or outside of) the multibeam path 103. The sensors 104A-D may be described as being positioned spaced away from the multibeam path 103. Ideally the sensors 104-D are located as close as possible to a multibeam path. However sensors 104A-D may be positioned outside of the multibeam path 103 due to a conflict in design space if the sensors were positioned inside the multibeam path 103. Sensors positioned within the multi-beam path would obstruct at least a sub-beam path; thus the sensors would block at least one of the sub-beams. For the reason of avoiding such conflict between the operation of the sensors 104A-D and the multibeam, the sensors are positioned so that they are spaced away from the multibeam path 103.

Each sensor 104A-D faces the sample 208 and is capable of measuring a distance Zm between the sensor 104A-D and the sample 208 (e.g., the distance between the sensor 104A-D and a portion of the sample surface facing the sensor 104A-D for example along the direction of the multibeam path 103). Each sensor 104A-D provides output data representing a result of the measurement. In some arrangements each sensor 104A-D comprises one or more capacitive sensors, optionally configured to operate in differential mode. The output data from the sensors 104A-D can be used for example by a controller 500 or a part or a constituent controller element of the controller 500 to control positioning of the sample 208 (including both position and orientation). Such control of the position of the sample 209 improves a quality of focus of one or more of the sub-beams on the sample 208. The aim is to position the portion of the sample surface processed by each sub-beam at or near the position of the focal plane for that sub-beam.

**FIG. 9** is a schematic side view of a portion of a sample 208 down-beam of an arrangement of the type shown in **FIG. 8**. In this case, the multibeam 102 is projected along multibeam path 103 from electron-optics of the charged particle device providing the multibeam 102 (which may include an objective lens array 401 comprising objective lenses and/or a detector module 402 having a detector; for example the detector module is the detector such as a detector array, as discussed above with reference to **FIG. 1-7**). In the example shown, which may be an idealized representation, the multibeam 102 has a common focal plane 108 for all sub-beams. The quality of focus will be acceptable for a range of positions of the sample surface close to the position of the focal plane 108. The range of positions may be defined by an upper limit 110 (e.g. an upper limit position) and a lower limit 112 (e.g. a lower limit position). The upper and lower limits depend on the focal range of the beams of the multibeam. The focal range of each beam may typically be of the order of $\pm$ 300nm or less. The focal range of the multibeam 102 will be the same but it will be harder to keep the surface of the sample 208 in the focal range as the multibeam 102 gets larger (i.e., as the field of view increases) because variations in flatness across the field of view will be larger. **FIG. 9** shows how variations in the topography of the sample 208 (which may be referred to as unflatness for example in a range with an upper limit of ten, twenty or even fifty micron) may cause focus problems. Such focus problems may be caused even if the sensors 104A-D indicate that the sample 208 is perfectly positioned, because the portions of the sample surface opposite the sensors 104A-D are positioned at the focal plane 108. The topography of the sample 208 causes the portion of the sample surface within the multibeam path 103 to be positioned outside of the range of positions that yield an acceptable quality of focus. At the same time, portions of the sample surface opposite the sensors 104A-D are positioned at the focal plane 108. Depending on the direction of curvature of the sample surface in the multibeam path 103 (convex or concave), the sample surface may be entirely below or above the range of positions defined by the upper limit 110 and the lower limit 112. This situation can be addressed by obtaining a topographical map of the sample surface beforehand. However obtaining such a map is time consuming. The topography of the sample surface may be dynamic; the topography of the sample surface can change over time. Such changes may be referred to as drift. Drift in the time interval between obtaining the topographical map and processing the sample using the multibeam can cause errors in focus. Positional (for example spatial degrees of freedom (e.g. along the directions of reference axes)) and/or orientation (for example angular degrees of freedom (e.g. angular displacements around the reference axes) corrections may be applied to the sample. The positional and/or orientation corrections to improve focus may be based on an inaccurate topographical map. Embodiments of the present disclosure aim to address these challenges.

In some embodiments, an electron-optical apparatus is provided for example as disclosed elsewhere herein. The electron-optical apparatus may be part of, or configured to operate as, an assessment apparatus for assessing (e.g., inspecting for defects) a sample 208 using a multibeam of charged particles (e.g., electrons). The electron-optical apparatus comprises a stage for supporting a sample 208 having a sample surface. The stage may take any of the forms described above with reference to **FIG. 2**. The stage may comprise an actuated stage 209 for example. The stage is controllable to adjust a position and/or orientation of the sample 208. The electron-optical apparatus comprises a charged particle device that projects a multibeam 102 along a multibeam path 103 towards the sample 208, for example as depicted schematically in **FIG. 9**. The multibeam 102 comprises a plurality of sub-beams of charged particles. The sub-beams have paths within the multibeam path 103 as described above. The paths may desirably be arranged in a grid which may be referred to as a beam grid. The paths may be such as to impinge on the sample in a plurality of localized regions defining the grid. Grid lines of the grid may define grid areas. The different grid areas may correspond to separate localized regions of a sample surface within the field of view of the beam grid that is processable by different sub-beams for example of the multibeam. In an embodiment, the grid lines may interconnect different beam paths. In another embodiment the grid lines may pass through points similarly distant, desirably equidistant, between two adjoining beams of the beam grid for example at a sample surface (or the portion of the sample surface processed the two adjoining beams of the multibeam). The localized region defined by grid lines may be a sub-beam processable area for processing by a respective sub-beam of the multibeam.

The multibeam path 103 intersects the sample 208 in a multibeam processable area 114. The multibeam processable area may comprise the sub-beam processable areas of the beam grid. The multibeam processable area 114 defines a region that can be processed by the multibeam for a given position of the multibeam 102 relative to the sample 208 (neglecting scanning of the sub-beams over small distances, such as distances between neighboring sub-beams). The charged particle device may take any of the forms described above for the charged particle device 41 (which may also be referred to as an electron-optical device or electron-optical column) with reference particularly to **FIG. 3** and 7.

The electron-optical apparatus may comprise a detector 240 which may be comprised within a detector module 402. The detector detects signal charged particles emitted from the sample 208. The detector generates detection signals on detection of the signal charged particles. The detector may take any of the forms described above for the detector 240 with reference particularly to **FIG. 2-7**. The detector may be comprised by a detector module 402 as described particularly with reference to **FIG. 3-6**. Processing of the sample 208 using the multibeam 102 may involve scanning the multibeam 102 over the sample surface and detecting signal electrons emitted from the sample surface using the detector. Images of scanned portions of the sample surface may be generated using an image acquirer as described above.

In some embodiments, the electron-optical apparatus comprises a sensing system. The sensing system comprises a plurality of sensors. Each sensor measures a position relative to the sensor of a respective portion of the sample surface outside of the multibeam processable area 114. The sensors may be configured to face the sample 208 and be capable of measuring a distance $Z_m$ between the sensor and the sample 208 as described above with reference to **FIG. 9** for sensors 104A-D. The distance may be referred to as a height of the sample surface. The distance may be along a direction orthogonal to a common plane of the sample surface and/or in a direction parallel to the direction of the multibeam path. The sensors may be capable of measuring for example in a direction of the multi-beam path and/or ideally orthogonal to a common plane of the surface of the sample and/or in a direction substantially orthogonal to a plane of a major surface of the sensor for example which in operation faces the surface of a sample. The common plane may be the best fit plane given the topography of the sample surface. Each sensor may provide output data representing a result of the measurement. In some arrangements each sensor 104A-D comprises one or more capacitive sensors, optionally configured to operate in differential mode. The sensors may be referred to as proximity sensors. The sensing system may be mounted to maintain a fixed spatial relationship with respect to the electron-optics of the charged particle device. The sensing system may, for example, be supported directly or indirectly by the charged particle device, or the charged particle device and the sensing system may together be supported by a common support element. Thus, relative movement between the stage and the charged particle device will involve corresponding relative movement between the stage and the sensing system. The spatial relationship between the positions on the sample surface measured by the sensors and the multibeam processable area will be remain substantially constant during the relative movement between the stage and the charged particle device.

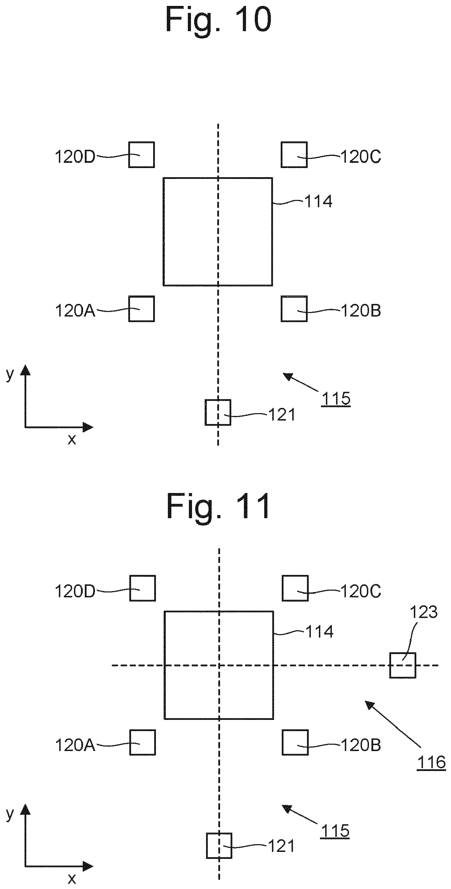

**FIG. 10-12** depict example positions of sensors 120-124 of the sensing system relative to the multibeam processable area 114 in a reference frame of the charged particle device. **FIG. 10-12** depict projections of positions of the sensors 120-124 and the multibeam processable area 114 onto a plane parallel to the sample 208 (or at least a common plane of the surface of the sample 208). These projections thus show the relative positions at which respective features of the electron-optical apparatus interact with the sample 208 (e.g., measuring positions of respective portions of the sample 208 in the case of the sensors 120-124 and assessing/inspecting the sample 208 in the multibeam processable area 114 in the case of the multibeam).

In some embodiments, as exemplified and labelled in **FIG. 10-12**, the sensors of the sensing system comprise a group of proximal sensors 120A-D. The proximal sensors 120A-D are positioned proximate to the paths of the plurality of sub-beams. The proximal sensors 120A-D are thus proximate to the multibeam path 103. Each proximal sensor 120A-D measures a position of a respective portion of the sample surface relative to that proximal sensor 120A-D (e.g., the portion of the sample surface closest (or facing) and/or directly underneath the proximal sensor 120A-D). Each proximal sensor 120A-D may measure a separation between the proximal sensor 120A-D and the respective portion of the sample surface. The portions of the sample surface measured by the proximal sensors 120A-D are proximate to the multibeam processable area 114.

In some embodiments, as exemplified and labelled in **FIG. 10-12**, the sensors of the sensing system comprise one or more distal sensors 121-124. Each distal sensor is positioned more remotely (i.e., further away) from the multibeam path 103 (or the paths of the sub-beams) than the proximal sensors 120A-D. The or each distal sensor 121-124 is configured to measure a position of a respective portion of the sample surface relative to the distal sensor 121-124. Each distal sensor 121-124 may measure a separation between the distal sensor 121-124 and the respective portion of the sample surface. The portions of the sample surface measured by the distal sensors 121-124 are further away from the multibeam processable area 114 than the portions of the sample surface measured by the proximal sensors 120A-D.

In an embodiment, a primary function of the proximal sensors 120A-D may be to provide direct input to a control system for positioning the actuated stage 209. In contrast, a primary function of the one or more distal sensors 121-124 may be to provide calibration information, e.g., to provide or refine a topographical map of the surface of the sample 208 that may calibrate or improve the positioning of the actuated stage 209 based on the outputs from the proximal sensors 120A-D. The one or more distal sensors 121-124 may thus be referred to as calibration sensors. As described below, however, in some embodiments the proximal sensors 120A-D and the distal sensors 121-124 are both used to obtain topographical information about the sample surface and are thus used for calibration purposes.

The proximal sensors 120A-D and the distal sensors 121-124 may be positioned at substantially the same distance from the stage and sample 208, for example in a same plane. Alternatively, two or more of the proximal sensors 120A-D and the distal sensors 121-124 may be positioned at different distances from the stage and sample 208.

The proximal sensors 120A-D and distal sensors 121-124 may be used to obtain topographical information about the sample surface. Topographical information includes information about the shape of the sample surface. For example, in a Cartesian reference frame a Z axis is parallel to the central path of the multibeam path 103 and/or geometrically: a principal axis of the multibeam and/or perpendicular to a nominally flat sample on the stage. In such a reference frame, the topographical information may comprise a map of a position along central path or a Z position (which may also be referred to as height) of the sample surface as a function of X and Y. A gradient (rate of change) of Z as a function of a direction within the XY plane may be referred to as a tilt of the sample surface for example relative to the multibeam path 103.

The proximal sensors 120A-D measure portions of the sample away from, or outside of, the multibeam processable area 114. However the portions of the sample 209 measured by the proximal sensors 120A-D are positioned close to and surrounding the multibeam processable area 114 for example as disclosed in US2011/0193574 which is hereby in incorporated by reference at least so far in generating a height map of at least a portion of a sample surface. The proximal sensors 120A-D are thus suited to determining topographical information about the sample surface near to or in the multibeam processable area 114. Combinations of the proximal sensors 120A-D can be used to be obtain tilt information about the sample surface in the multibeam processable area 114. Proximal sensors 120A and 120B (or proximal sensors 120C and 120D) could be used to obtain information about tilt relative to the Y axis, for example about the Y axis in the multibeam processable area 114, for example about an axis in a first direction of a common plane of a surface of a sample. Similarly, proximal sensors 120A and 120D (or proximal sensors 120B and 120C) could be used to obtain information about tilt relative to the X axis (for example about the X axis) in the multibeam processable area 114, for example about an axis in a second direction of the common plane of the surface of the sample angled relative, for example orthogonal, to the first axis in the common plane. By being positioned further away from the multibeam, the one or more distal sensors 121-124 enable information to be obtained about sample surface topography further away from the multibeam processable area 114.

Referring to **FIG. 10**, for example, distal sensor 121 can be used to obtain not only information about the height of the sample surface directly underneath (or facing) the distal sensor 121 but also information about tilt in the region 115 outside of the multibeam processable area 114. That is the distal sensor 121 may be used to obtain information about the height of a portion of the sample surface facing the distal sensor 121 and the tilt of an adjacent portion that is remote from the processable area 114 (which may be considered as an external region 115 that may be outside multibeam processable area 114). Through the multibeam processable area 114 is a route represented by dotted lines. The route partitions the multibeam processable area 114 into two parts. The two parts of the multibeam processable area may have similar area, even the same area so that the route divides the multibeam processable area 114 into two. The distal sensor 121, which may be referred to as a primary distal sensor, may be positioned on the direction of the route (or the primary route), for example on the route, when the route is extended outward from the multibeam processable area 114. The primary distal sensor 121 may be on the route. A combination of measurements from distal sensor 121 and proximal sensors 120A and 120B can provide information about tilt relative to both X and Y axes in the region 115.

Referring to **FIG. 11**, for example, distal sensor 121 (or primary distal sensor 121), as shown and described with reference to **FIG. 10**, may be used to obtain information about the height of a portion of the sample surface facing the distal sensor 121 and the tilt of an adjacent remote from the processable area 114 (which may be considered in an external region 115 that may be outside multibeam processable area 114). The primary distal sensor 121 may be positioned on the route. Similarly, distal sensor 123 can be used to obtain not only information about the height of the sample surface directly underneath the distal sensor 123 but also information about tilt in the region 116 outside of the multibeam processable area 114. That is the distal sensor 123 (or secondary distal sensor) may be used to obtain information about the height of a portion of the sample surface facing the secondary distal sensor 121 and the tilt of an adjacent portion that is remote from the processable area 114 (which may be considered in an external region 116 that may be outside multibeam processable area 114). Through the multibeam processable area 114 is a route, for example a secondary route, represented by a dotted line. The route partitions the multibeam processable area 114 into two parts. The two parts of the multibeam processable area may have similar area, even the same area so that the secondary route divides the multibeam processable area 114 into two. The secondary route may have a different direction in the common plane of the multibeam processable area 114 for example in common plane of the multibeam processable area 114; for example the secondary route may be orthogonal to the primary route. The secondary distal sensor 123 may be positioned on the direction of the secondary route, for example on the route, when the route is extended outward from the multibeam processable area 114. The secondary distal sensor 123 may be on the secondary route. As mentioned, a combination of measurements from distal sensor 121 and proximal sensors 120A and 120B can provide information about tilt relative to both X and Y axes in the region 115. A combination of measurements from distal sensor 123 and proximal sensors 120B and 120C can provide information about tilt relative to X and Y axes in the region 116. (It should be noted that the numerical references to the sensors 121, 123, are a label of convenience and does not necessarily indicate the relative priority or importance of the sensors).

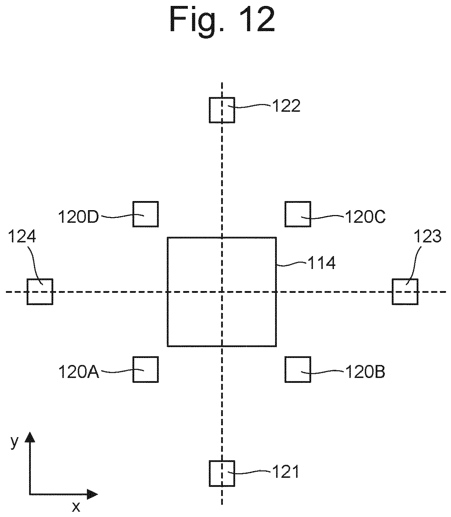

Referring to **FIG. 12**, the features common to **FIG. 11** have the same description as provided for **FIG. 11.** In addition, the further distal sensors 122 and 124, which may be referred to as a tertiary sensor 122 and a quaternary sensor 124 respectively, are provided. The tertiary sensor 122 may be positioned in the direction of the primary route relative to the multibeam processable area 114 or even on the primary route. The tertiary sensor 122 may be positioned on the opposite side of the multibeam processable area 114 from the primary sensor 121. The quaternary sensor 124 may be positioned in the direction of the secondary route relative to the multibeam processable area 114 or even on the secondary route. The quaternary sensor 124 may be positioned on the opposite side of the multibeam processable area 114 from the secondary sensor 123. (It should be noted that the numerical references to the sensors 121, 122, 123, 124 are a label of convenience and does not necessarily indicate the relative priority or importance of the sensors).

The sample 208 may be processed by the multibeam (e.g. assessed such as inspected or measured) by moving the multibeam over the sample 208 along a processing path such as one of the primary and secondary routes. This may be achieved by providing relative movement between the multibeam processable area 114 and the sample 208, for example by moving the stage. The multibeam processable area 114 is moved along the processing path, for example as represented by one of the dotted lines (e.g. the primary route and/or the secondary route), for example in a direction corresponding to the y axis in a Cartesian frame of reference, e.g. in a reference frame of the sample 208. The distal sensors can be used to obtain topographical information about the sample surface in selected portions of the processing path before the multibeam processable area 114 reaches those portions. The topographical information is thus available in time to be used to improve the processing. The position and/or orientation of the sample 208 (e.g. Z position or height) can be adjusted for example along the direction of the multibeam path, for example, based on the obtained topographical information for a selected portion of the processing path relative to the multibeam path, for example when the multibeam processable area 114 reaches that selected portion. The adjustment may improve focusing (or at least the quality of focusing of the multibeam, and the variations in focusing of the different beams of the beam array) during the processing. It may be possible for example to improve on the approach **FIG. 9.** In the approach shown in and described with reference to **FIG. 9** a sample 208 is positioned based only on aiming for the sample surface to coincide with a focal plane 108 at positions corresponding to proximal sensors. For example, in the situation shown in **FIG. 9** the sample 208 may be positioned at a distance for example further up beam (e.g. up the multi-beam path), such that at least part of a portion of the sample surface in the multibeam processable area 114 is moved so that the portion of the sample corresponding to the multibeam processable area 114 is within the range of positions for example between the upper limit position and the lower limit position. That is the range of positions is defined by the upper limit 110 and the lower limit 112. The portion of the sample corresponding to the multibeam processing area 114 may be positioned within the range of position rather than at a position remote of the range of position, (i.e. outside of the range).

In the example of **FIG. 11**, if the multibeam processable area 114 is moved over regions 115 and/or 116 after those regions have been measured using the distal sensors 121 (e.g. the primary distal sensor) and/or 123 (e.g. the secondary distal sensor), the topographical information obtained by those distal sensors can be used to improve focus when the multibeam processable area 114 passes over the regions 115 and/or 116. Because the topographical measurements of the regions 115 and/or 116 are made just before the same regions are processed by the multibeam (e.g., while the multibeam processable area 114 is being moved along an earlier portion of the processing path), this approach may be referred to as "on-the-fly" obtaining of topographical information about the sample surface. The on-the-fly nature of the approach avoids or reduces the need to obtain a topographical map in a separate process beforehand. Scanning the surface using the sensor or otherwise generating the sample map is no longer necessary. It is no longer necessary for a separate pre-scan for generating the sample map. The sample processing time may therefore be reduced by the time used to generate the sample map. The time may be used for sample processing thereby increasing throughput. At the same time, the topographical information can be obtained sufficiently ahead of time to allow appropriate position/orientation corrections to be made without slowing down the processing being performed by the multibeam.

As mentioned **FIG. 12** shows an arrangement where further distal sensors 122 and 124 are provided (for example the tertiary and quaternary sensors). These further distal sensors 122 and 124 provide flexibility for moving the multibeam processable area 114 over the sample surface in different directions (for example the reverse of the relative motion between the sample 209 and the multibeam path 103 such as along one of the primary and secondary routes). These further distal sensors 122 and 124 provide flexibility for moving the multibeam processable area 114 while still being able to obtain relevant topographical information about portions of the sample surface in advance of those portions being processed by the multibeam. Further details about options for geometrically arranging the sensors are described later on in the description below.

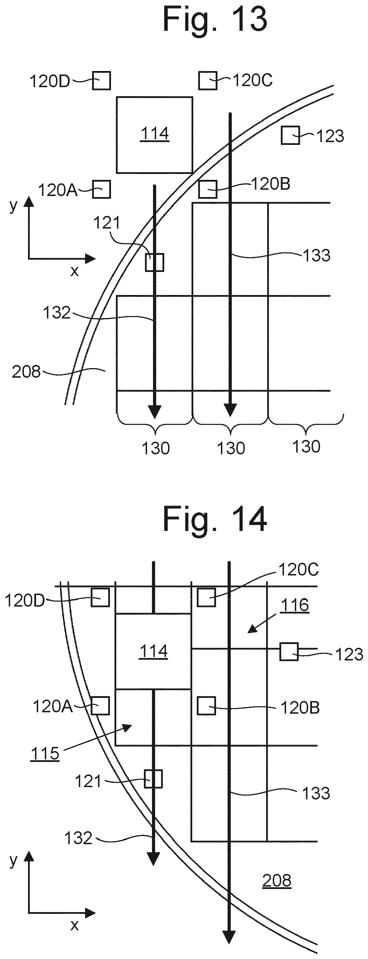

**FIG. 13-17** depict different stages of embodiments of processing a sample 208 using the sensor arrangement shown in **FIG. 11**. In each figure, positions of the different sensors 120, 121, 123 (for example proximal sensors 120 and the primary and secondary sensors 121, 123) are projected onto the plane of the sample 208 (such as a common plane to the sample surface) to show the relative positions of portions of the sample surface measured by the sensors and the multibeam processable area 114. In this example, the sample 208 is processed by moving the multibeam processable area 114 along a processing path comprising a sequence of parallel routes 132, 133. Such a parallel route may correspond to the primary route shown in and described with references to **FIG. 11** or **12.** (It should be noted that this description refers to the multibeam processable area 114 and the sample surface being moved relative to each other such that the multibeam processable area 114 (or alternatively expressed the multibeam path 114) traverses over the surface of the sample, in the frame of reference of the sample, in a sequence of parallel routes 132, 133. In the following description, for the sake of convenience of expression, reference to movement of the multibeam processable area 114 over the sample surface is an expression of such relative motion between the multibeam processable area 114 and the sample surface in the frame of reference of the sample).

**FIG. 13** depicts a stage which may be an initial stage of an embodiment in which the multibeam processable area 114 (or alternatively expressed the multibeam path) is approaching the sample 208 from a region outside of the sample 208 (for example in the frame of reference of the sample 208). In the initial stage, the sample is positioned so that the sample surface does not face the multibeam path 103. At this stage the multibeam processable area 114 and three of the four proximal sensors 120 are not over the sample 208 but the distal sensors 121 and 123 are. That is the sample is positioned to face the distal sensors 121, 123 and one of the four proximal sensors 120, for example the proximal sensor 120B positioned closest to the distal sensors 121, 123 in the frame of reference of the distal sensors for example in between the two distal sensors 121, 123. The distal sensors 121 and 123 enable detailed information about sample topography to be obtained at an earlier stage of processing the sample than would be possible without the distal sensors.

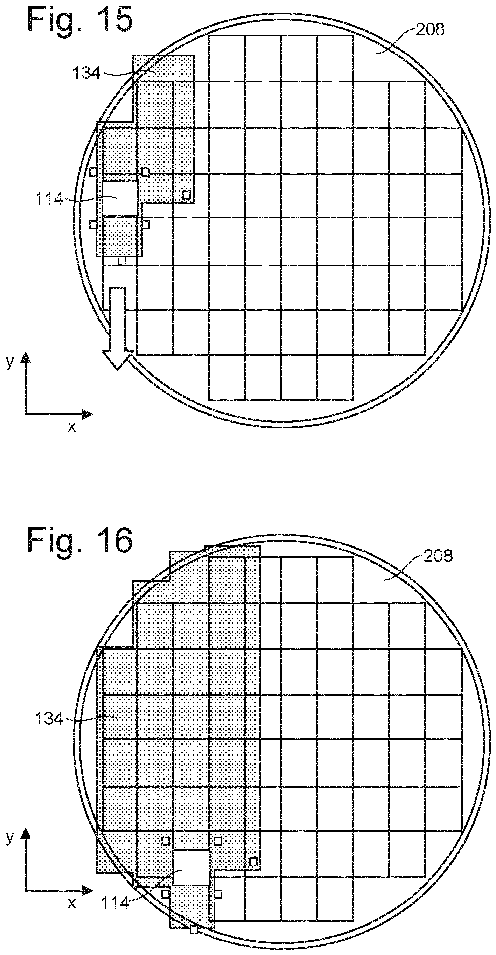

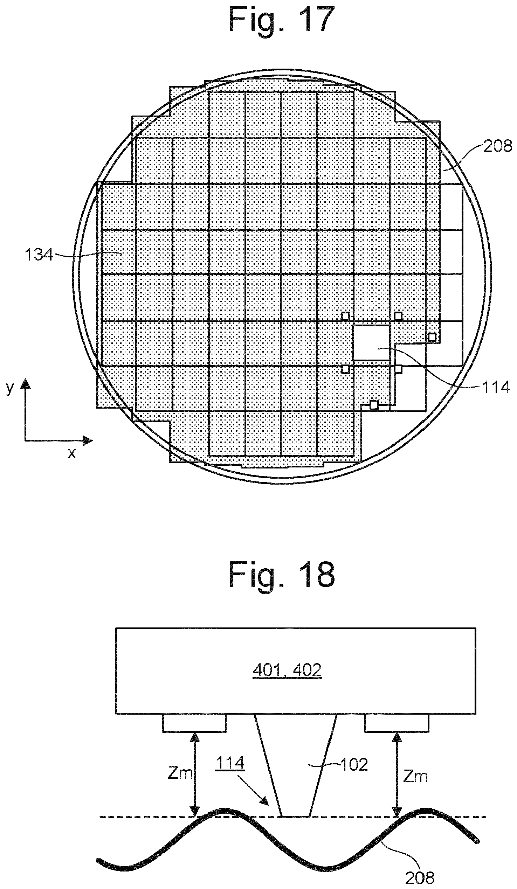

**FIG. 14** depicts a later stage of processing the same routes 132, 133 as features in **FIG. 13.** The arrows associated with the routes 132, 133 indicate the relative direction of movement of the multibeam processable area 114 along the routes 132, 133 for example in the frame of reference of the sample. In this example, the surface of the sample 208 faces the distal sensors 121, 122, the proximal sensors 120A, 120B, 120C, 120D, and the multibeam path 102. The sample topography is measured in region 115 (or an advance region relative to the multibeam processable area) by the distal sensor 121 and optionally the proximal sensors 120A and 120B while a portion of the sample surface at the multibeam processable area 114 is processed. The portion of the sample surface at multibeam processable area 114 was earlier a region 115 in advance of the multibeam processable area 114 in the same route 132; that is before the multibeam processable area 114 moves over the sample surface measured by at least the distal sensor and a portion further along the route 132 becomes the region 115 relative to the multibeam processable area 114. At the same time, sample topography can be measured in region 116 by the distal sensor 123 and optionally the proximal sensors 120B and 120C. Relative to the multibeam processable area 114, region 116 relates to a sample portion in a neighboring route 133 to the route 132. In this example, topographical information can be obtained about substantially all of this neighboring route 133 before the multibeam starts to process this route 133 (or alternatively expressed the multibeam processable area 114 is moved over the sample surface along the route 133). **FIG. 15-17** illustrate schematically how the processing of **FIG. 13** and **14** may proceed at the level of the whole sample 208 for progressively later stages of the processing. Each of the figures **FIG. 15 to 17** may represent successive stages of the processing in the order **FIG. 15**, the **FIG. 16** and then **FIG. 17.** The shaded region 134 of each of these figures indicates the portion of the sample 208 for which topographical information has been obtained using at least the distal sensors 121, 123. The shaded region 134 shows how the topographical information is obtained from regions of the sample surface ahead of the position of the multibeam processable area 114 as the multibeam processable area 114 is moved over the sample surface along the processing path. The shaded region 134 comprises regions of the sample surface both within the same route 132 as the position of the multibeam processable area 114 and in the next route 133 along for example over which the multibeam processable area 114 is yet to pass. (Note the next route 133 may correspond to the neighboring route 133 directly to the side of the same route 132, for example adjacent to the same route 132, further along the x axis in a Cartesian coordinates of the sample surface; or to the right of the same route 132 as shown in any of **FIG. 15 to 17**).

Functionality such as that described above may be implemented using a control system 500. The control system 500 controls the electron-optical apparatus to perform the functionality. The control system 500 may comprise or consist of a controller 50 taking any of the forms described above with reference to **FIG. 1.** The control system 500 may cause the electron-optical apparatus to perform the functions by controlling the stage, the charged particle device and/or the detector. The control system 500 may comprise a single unit configured to perform all of the control functionality or may comprise a distributed system of units that together allow the required functionalities to be achieved. The control system 500 may be at least partially computer implemented. Any suitable combination of elements (e.g., CPUs, RAM, data storage, data connections, sensors, etc.) may be provided and suitably programmed to achieve the specified functionality. Any reference herein to an apparatus, device or system being configured to perform functionality is intended to encompass the case where the control system 500 is configured to cause the functionality to be performed (e.g., by being suitably programmed to provide control signals that cause the functionality to happen).

In an embodiment, the control system 500 controls the charged particle device to process the sample surface in the multibeam processable area 114. The processing may comprise assessing or inspecting the sample surface using the multibeam. As described above, this may be done by detecting signal electrons emitted from the sample surface using a detector 240.

In an embodiment, the control system 500 controls the stage 209 to cause the multibeam processable area 114 to move along a processing path in a reference frame of the sample 208. A region on the sample surface can be processed by the multibeam when the multibeam processable area 114 is positioned to encompass the region. Moving the multibeam processable area 114 along the processing path thus allows areas larger than the area of the multibeam processable area 114 to be processed. The processing path may be selected to allow processing of a large proportion of the sample surface as exemplified in **FIG. 13-17** above. Alternatively, one or more localized regions of interest may be targeted more specifically. Obtaining the topographical information on-the-fly in regions close to the multibeam processable area 114 makes it possible to target localized regions of interest more efficiently. It is not necessary, for example, to obtain a topographical map of the whole sample 208 beforehand or know specifically in advance which regions are to be targeted. The on-the-fly approach provides flexibility for obtaining only the topographical information that is needed for a particular assessment/inspection task. Reference is made to the multibeam processable area 114 moving along a processing path relative to the sample 208 for ease of visualization. In practice, when considered in the frame of reference of the electron-optical device, the relative movement between the multibeam processable area 114 and the sample 208 will typically be provided, mostly or entirely, by moving the sample 208 rather than the multibeam processable area 114.

In an embodiment, the control system 500 controls the sensing system to use at least the one or more distal sensors 121-124 to obtain topographical information about the sample surface in a selected portion of the processing path before the multibeam processable area 114 reaches the selected portion of the processing path. The regions 115 and 116 discussed above are examples of such selected portions relative to the multibeam processable area 114. The region 115 may be referred to as an advance region 115; the region 116 may be referred to as a side region 116. That is the regions 115 and 116 (or an advance region 115 and a side region 116) are moved over the sample surface so that topographical information of the portions of the sample surface may be obtained, the portions of the sample surface corresponding to the advance region 115 and/or a side region 116 relative to the position of the multibeam possessable area 114 on the sample surface along the processing path 132. The control system 500 may be configured to control the sensing system and the charged particle device to obtain topographical information and process the sample surface in different respective portions of the processing path at the same time. This is exemplified in **FIG. 14**, for example, where topographical information can be obtained in regions 115 and 116 at the same time as processing the sample in the multibeam processable area 114. The advantages of this on-the-fly approach have been discussed above.

Further details are now given about options for positioning the sensors.

As described above, to achieve the on-the-fly functionality, the one or more distal sensors 121-124 comprise at least one distal sensor 121, 123 positioned ahead of the multibeam processable area 114 along the processing path. The positioning of the sensors may thus depend on details of the processing path that is used.

In some embodiments, as exemplified in **FIG. 13-17,** the processing path comprises a plurality of routes 132, 133 (which may be referred to for ease of reference by the reference 132). Each route 132 is a part of the processing path. The routes 132 may be parallel to each other. The routes 132 may be straight (as shown) or curved or comprise straight and curved elements. The routes 132 are offset with respect to each other. The offset is in an offset direction across the sample surface for example representing a displacement of the multibeam processable area 114 and the sample relative to each other. The offset direction in the example shown in **FIG. 13-17** is horizontal (left to right) in the plane of the page. The offset size may be substantially equal to or less than a dimension (e.g., width) of the multibeam processable area 114 parallel to the offset direction. Strips 130 (for example of the sample surface) processed by moving the multibeam processable area 114 along adjacent routes will thus be contiguous or partially overlapping. The control system 500 may cause the multibeam processable area 114 to move along the routes in sequence. The control system 500 may displace the multibeam processable area 114 and the routes 132 relative to each other between processing of different routes 132 of the processing path, desirably in the offset direction across the sample surface. The control system 500 may be configured to displace the sample 208 and the grid (and therefore the multibeam processable area 114) relative to each other between different routes of the processing path across the sample surface. The control system 500 may be configured to move the sample 208 and the grid (and therefore the multibeam processable area 114) relative to each other between routes desirably in sequence. In the example shown, the routes 132 are depicted as arrows that all point downwards to indicate a direction of movement of the multibeam processable area 114 along the routes. In other embodiments, the routes 132 may alternate in direction to reduce the overall distance that the stage needs to be moved to process all of the routes 132.

In some embodiments, the one or more distal sensors 121-124 comprises at least one distal sensor 121 positioned relative to the multibeam processable area 114 to measure a portion of the sample surface in the same route 132 as the multibeam processable area 114 (e.g., while the multibeam is processing a different portion of the sample surface in the same route). The one or more distal sensors 121-124 may thus comprise at least one distal sensor positioned relative to the grid and the processing path to measure a portion of the sample surface in the same route. In the case where the distal sensor 121 in the same route 132 is positioned ahead of the multibeam processable area 114, the distal sensor 121 may be referred to as a forward sensor 121 or leading sensor 121. Such a forward sensor 121 is positioned to measure a portion of the sample surface in the same route 132 before the multibeam processable area 114 is moved over that portion of the sample surface and is exemplified in **FIG. 14** for example. **FIG. 10** depicts an example arrangement in which the only distal sensor provided is a forward sensor 121. **FIG. 11-12** depict example arrangements having such a forward sensor 121 together with other distal sensors. (Note if the direction of relative movement between the multibeam processable area 114 and the sample surface is different for example in the opposite direction along the route, or the route is in a direction orthogonal to the routes depicted in **FIG. 13 to 17**, another of the distal sensors 122, 123, 124 may function as a forward sensor. The description herein relating to the forward sensor may apply accordingly to another arrangement in which any of the distal sensors 122, 123, 124 functions as the forward sensor.)

In some embodiments, the at least one distal sensor 121-124 comprises a distal sensor 121 positioned substantially centrally with respect to a dimension of the multibeam processable area 114 perpendicular to relative movement of the multibeam processable area 114 along the route 132. The distal sensor may thus be positioned substantially centrally with respect to a dimension of the grid proximate the sample surface orthogonal to the multibeam path. The forward sensor 121 shown in **FIG. 10-12** is positioned in this manner. Positioning a distal sensor 121 centrally in this way allows the distal sensor 121 to obtain topographical information directly about a portion of the sample surface over which a central portion of the multibeam processable area 114 will pass. The forward sensor 121 may, however, be positioned off center and still be able to obtain useful topographical information. The forward sensor 121 is desirably positioned to at least be able to measure a portion of the sample surface over which a part of the multibeam processable area 114 will pass during movement along the route 132 of the processing path, for example corresponding to the advance region 115.

In some embodiments, the at least one distal sensor 121-124 comprises a rear sensor 122 (which may alternatively be referred to as a trailing sensor 122) and the forward sensor 121. The rear sensor 122 sensor and the forward sensor 121 may be positioned to be able to simultaneously measure portions of the sample surface on opposite sides of the multibeam processable area 114. The rear sensor 122 and the forward sensor 121 may be displaced from the grid along a same route. An example configuration of this type is depicted in **FIG. 12.** In this view the rear sensor 122 and forward sensor 121 are on opposite sides of the multibeam processable area 114. Providing both rear and forward sensors ensures that a distal sensor is always present ahead of the multibeam processable area 114 regardless of the direction of processing of the routes 132. If the direction of processing is reversed, the roles of the rear and forward sensors reverses, with the forward sensor becoming the rear sensor and the rear sensor becoming the forward sensor.

In some embodiments, the one or more distal sensors 121-124 comprises a side sensor 123, 124 positioned to measure a portion of the sample surface in one of the routes 133 before the multibeam processable area 114 is moved over that portion of the sample surface and while the multibeam processable area 114 is within a different one of the routes 132. Relative to the multibeam processable area 114, the portion of the sample surface facing one of the side sensors 123 may correspond to the side region 116. The side sensor 123 may thus be positioned to measure a portion of the sample surface in a different route 133 from the route 132 in the multibeam path 103. **FIG. 11** and **12** show example arrangements having such a side sensor 123, 124. The provision of a side sensor 123, 124 thus allows topographical information to be obtained about a portion of the sample surface in a route 132 before processing of the route is even started (while the multibeam 102 is processing a neighboring route 132). The side sensor 123, 124 may be positioned to measure a portion of the sample surface that is substantially aligned with a center of the multibeam processable area 114 in a direction perpendicular to relative movement of the multibeam processable area 114 along one of the routes (e.g., as shown in **FIG. 11** and **12**, the side sensors 123, 124 may measure portions aligned with the center of the multibeam processable area 114 in the horizontal direction). The one or more distal sensors may thus comprise a side sensor positioned away from the grid in a direction orthogonal to the processing path, desirably at a different side of the grid from a forward or rear sensor.

In some embodiments, as exemplified in **FIG. 12**, two side sensors 123, 124 are provided, which may be referred to as a first side sensor 123 and a second side sensor 124. The first side sensor 123 and the second side sensor 124 may be positioned to be capable of simultaneously measuring portions of the sample surface on opposite sides of the multibeam processable area 114, desirably within different routes 132 from the route in which the multibeam processable area 114 is located at that time. The second side sensor 124 may thus be positioned on an opposite side of the grid from the first side sensor 123.

The spatial distribution of the group of proximal sensors 120 is not particularly limited. Providing multiple proximal sensors makes it possible to obtain tilt information and allows reliable Z measurements to be made even towards the edges of the sample 208. In some embodiments, the group of proximal sensors comprises four proximal sensors positioned to measure four respective portions of the sample surface defining vertices of a four-sided shape. As exemplified in **FIG. 10-14,** the four-sided shape may be a rectangle for example a square. The four-sided shape may be centered on the multibeam processable area 114 (such that the corresponding sensors 120 are positioned to define vertices of a four-sided shape centered on the multibeam for example a central path of the multibeam path 103). In embodiments of this type, the one or more distal sensors 121-124 may comprise a first distal sensor 121 positioned to measure a respective portion of the sample surface that is aligned with a center of the rectangle in a direction parallel to a first side of the rectangle (i.e., one of the horizontal sides of the rectangle formed by the projected positions of proximal sensors 120A-D in **FIG. 10-14,** which respectively define the portions of the sample surface defining the vertices of the rectangle).

In some embodiments, the one or more distal sensors further comprises a second distal sensor 123 positioned to measure a portion of the sample surface that is aligned with the center of the rectangle in a direction parallel to a second side of the rectangle. The second side may be orthogonal to the first side. In the example of **FIG. 11-14,** the second side of the rectangle is one of the vertical sides of the rectangle formed by the projected positions of proximal sensors 120A-D.

As described above, it is desirable to use topographical information about the sample surface in the multibeam processable area 114 to correct for unflatness during processing by a multibeam. In the embodiments described above, the topographical information is obtained on-the-fly using distal sensors positioned ahead of the multibeam processable area 114 (in combination with proximal sensors). In other arrangements, a topographical map of the whole surface may be obtained beforehand. A Z position of a portion of the sample surface (for example displacement of the sample surface in a direction parallel to the multibeam path) corresponding to the multibeam processable area 114 may be controlled by reference to an output from a proximal sensor. For example, in an arrangement of the type shown in **FIG. 8**, the Z position may be controlled by reference to an output from the sensor 104A, with a correction applied that is derived from the previously obtained topographical information. The desired correction is:

$$ Z_{waf}(X_{EO}, Y_{EO}) - Z_{waf}\left(X_{EO} - \frac{dX}{2}, Y_{EO} - \frac{dY}{2}\right) \qquad (1) $$

where: $Z_{waf}(X, Y)$ is the Z position of the sample (wafer height) as a function of horizontal coordinates; $(X_{EO}, Y_{EO})$ is the XY-position corresponding to the center of the electron-optics (EO) and multibeam processable area 114; and $dX$ and $dY$ are the spacings along $X$ and $Y$ of the sensors ($dX$ is the spacing between sensors 104A and 104B and between 104C and 104D; $dY$ is the spacing between sensors 104A and 104D and between 104B and 104C).

If the topological information is obtained simply by scanning a single sensor over the whole sample surface to obtain a map of $Z_{waf}(X, Y)$ with the Z position of the stage controlled by a stage measurement system (such as an interferometer system), inaccuracies of the stage measurement system (e.g., due to mirror unflatness in an interferometer system) will be included, which is undesirable. As shown in expression (1) above, the desired correction involves only unflatness in the sample.

An approach that reduces or avoids involvement of inaccuracies in the stage measurement system is to use differences between measurements from different proximal sensors. For example, in the example discussed above, where the outputs from sensors 104A-D are respectively represented as $Z_A$, $Z_B$, $Z_C$, $Z_D$, instead of using only the output $Z_A$, the differences $Z_D - Z_A$, $Z_C - Z_A$, and $Z_B - Z_A$ may be used, which are independent of the inaccuracies of the stage measurement system. A weakness of this approach, however, is that it is not sensitive to all types of sample unflatness. For example, as depicted schematically in **FIG. 18**, the approach will not be able detect certain periodic features or characteristics of the surface topography of the sample which relate to the positioning, for example the geometric arrangement of the different sensors 120A -D relative to the multibeam path 103. For example the approach is unable to detect to spatial Fourier components of $Z_{waf}(X,Y)$ having wavelengths equal to $dX$ along the X direction or equal to $dY$ along the Y direction, in the case where proximal sensors are arranged to form a rectangle having sides aligned along X and Y as shown in **FIG. 8**. As can be seen in **FIG. 18**, it is desirable to correct for such spatial components because they can cause significant errors in focus. Preliminary numerical studies suggest that a local sample unflatness having such a spatial component with a magnitude of $H$ would cause an error in a calculated sample surface height correction of $H/4$.

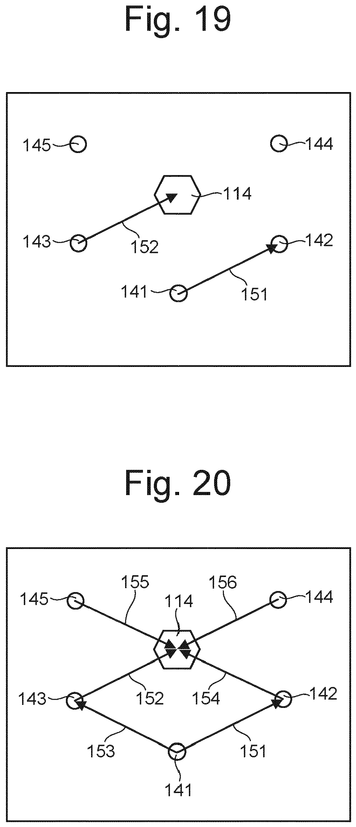

In a similar way to the embodiments discussed above with reference to **FIG. 10-17**, the above issue is addressed according to embodiments of the present disclosure by providing one or more additional, optionally distal, sensors. Variations on the embodiments of electron-optical apparatuses and methods described above with reference to **FIG. 10-17** are thus now described with reference to **FIG. 19-21**. The electron-optical apparatus according to the present class of embodiment comprises a stage configured to support a sample 208, a charged particle device configured to project a multibeam towards the sample 208 and a sensing system comprising a plurality of sensors. The stage, charged particle device and/or sensing system may be configured and/or arranged to operate in any of the ways described above with reference particularly to the embodiments of **FIG. 10-17**. The arrangements described in and shown in reference to **FIG. 19-21** may take the same features as described with reference to and shown in **FIG, 10-17** unless stated to the contrary.

**FIG. 19** and **20** depict projections of positions of sensors 141-145 of the present class of embodiment and the multibeam processable area 114 onto a plane substantially parallel to the sample 208. The projections illustrate the relative positioning of the sensors 141-145 and the multibeam processable area 114 when viewed along a direction towards the sample 208 and parallel to a principal axis of the multibeam 102 (typically vertically downwards). Sensors 143, 142, 144, and 145 in this example are positioned in the same way, respectively, as sensors 104A-D in **FIG. 8**.

In this class of embodiment, the plurality of proximal sensors comprises at least a first sensor 141, a second sensor 142, and a third sensor 143. (The first sensor 141 may correspond to the distal sensor 121 (or primary distal sensor). The second sensor 142 may correspond to proximal sensor 120B. The third sensor 143 may correspond to the proximal sensor 120A. The first sensor 141 with respect to the proximal sensors 142 to 145 or 120A-D may be referred to as the 'fifth sensor'). The first sensor 141, second sensor 142, and third sensor 143 are positioned such that, in a projection of positions of the sensors and the multibeam processable area 114 onto a plane parallel to the sample 208, as depicted in **FIG. 19**, a vector 151 joins the positions of the first sensor 141 and the second sensor 142. The vector 151 is substantially equal or opposite to a vector 152 joining a position of the third sensor 143 to a center of the multibeam processable area 114 (or the intersection of the central path of the multibeam path 103 and the plane parallel to the sample for example onto which the positions of the sensors 141to 145 are projected). The vector 152 may be referred to as a proximal vector, between one of the proximal sensors 143 and the center of the multibeam processable area 114. The vector 151 may be referred to as a distal vector, between the distal sensor or first sensor 141 and the center of the multibeam processable area 114.

The equal or opposite nature of the distal and proximal vectors 151, 152 makes it possible to determine, using the first and second sensors 141, 142, a difference in height between two positions on the substrate surface that have the same spatial relationship relative to each other as the spatial relationship between the third sensor and the center of the multibeam processable area 114. This makes it possible to derive a height of the sample surface at the center of the multibeam processable area 114 from a single measurement by the third sensor 143, despite no sensor being able to directly measure the height of the sample surface at the center of the multibeam processable area 114. The measurement by the third sensor 143 may be considered to be a calibration or correction. The third sensor 143 may be referred to as a calibration sensor.

The correction term given by expression (1) above corresponds to the proximal vector 152 shown in **FIG. 19**. Relative to the arrangement of **FIG. 8**, the first sensor 141 provides the additional option of measuring a distal vector 151 that is the same or opposite to the proximal vector 152. The difference in height, or Z position, of the sample surface, that is measured by the second sensor 142, $Z_2$, for example with respect to a facing portion of the sample surface, and the first sensor 141, $Z_1$, for example with respect to a facing portion of the sample surface when the multibeam processable area 114 is positioned over an arbitrary portion of the sample surface ($X_{EO}, Y_{EO}$) may be written as follows:

$$Z_2 - Z_1 = Z_{waf}\left(X_{EO} + \frac{dX}{2}, Y_{EO} - \frac{dY}{2}\right) - Z_{waf}(X_{EO}, Y_{EO} - dY). \qquad (2)$$

This difference for example in height provides the desired correction for the case when the multibeam processable area 114 is positioned relative to the sample at the location ($X_{EO} + \frac{dX}{2}, Y_{EO} - \frac{dY}{2}$), which may be referred to as a correction location. For example, the first sensor 141 and the second sensor 142 may be scanned relative to the sample 208 to obtain a dataset representing respective maps (for example height maps) $Z_1(X,Y)$ and $Z_2(X,Y)$. Shifting this dataset by a shift vector provides respective shifted maps, e.g. height maps, of the sample surface $Z'_1(X,Y)$ and $Z'_2(X,Y)$. In this particular example, if the shift vector is ($-\frac{dX}{2}, \frac{dY}{2}$) the respective shifted maps provide the correction required to use an output from the third sensor 143 to obtain $Z_{waf}(X_{EO}, Y_{EO})$. A shift vector of ($-\frac{dX}{2}, \frac{dY}{2}$) represents a shift of half the distance between the first and third sensors 142 and 143 along the X direction and a shift of half the distance between the second and fourth sensors 142 and 144 along the Y direction. Due to the symmetry in the positions of the first, second and third sensors 141, 142, 143, in the example shown the shift vector has the same magnitude as the distal and proximal vectors 151, 152. In other embodiments, the shift vector may have a different magnitude to the distal and proximal vectors 151, 152. The relationship between the shifted maps may be expressed as

$$Z'_2 - Z'_1 = Z_{waf}\left(X_{EO} + \frac{dX}{2} - \frac{dX}{2}, Y_{EO} - \frac{dY}{2} + \frac{dY}{2}\right) - Z_{waf}\left(X_{EO} - \frac{dX}{2}, Y_{EO} - dY + \frac{dY}{2}\right)$$

$$= Z_{waf}(X_{EO}, Y_{EO}) - Z_{waf}\left(X_{EO} - \frac{dX}{2}, Y_{EO} - \frac{dY}{2}\right). \qquad (3)$$

Expression (3) shows that the difference between the shifted maps is expression (1). The shifted maps obtained from the outputs of the first and second sensors 141 and 142 thus provide correction data that make it possible to use an output from the third sensor 143 to deduce unflatness in the multibeam processable area 114 during subsequent processing. The position of the sample (e.g., height) can then be controlled accurately using the output from the third sensor 143 even in the case of unflatness of the type shown in **FIG. 18** and without interference from inaccuracies of the stage measurement system such as mirror unflatness. The correction data can be obtained on-the-fly (at the same time as processing is being performed by the multibeam) or beforehand (before processing by the multibeam is started). Although the description refers to the first sensor 141 (or fifth sensor) being the primary distal sensor 121, any of the distal sensors 122, 123, 124 may function as the first sensor 141, with the relevant specific proximal sensor and their functions as described relative to the primary distal sensor 121 mapped over.

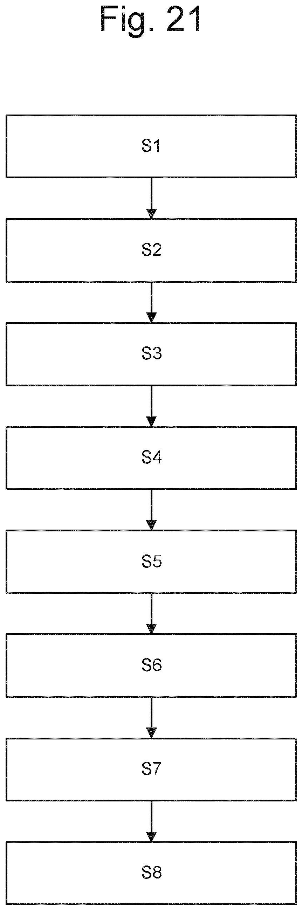

In some embodiments, a methodology such as that shown in **FIG. 21** may be used. The methodology may be implemented using the control system 500 to control the stage and sensing system.

In step S1, the multibeam processable area 114 is positioned at a first position on the sample surface.

In step S2, measurements of the sample surface are obtained using the first sensor 141 and the second sensor 142 while the multibeam processable area 114 is at the first position.

In step S3, a correction value is generated using the measurements obtained by the first sensor 141 and the second sensor 142 while the multibeam processable area 114 is at the first position. The correction value may, for example, comprise a difference between a height of the sample surface measured by the first sensor 141 and a height of the sample surface measured by the second sensor 142.

In step S4, the multibeam processable area 114 is moved to a second position on the sample surface. Preferably, the second position of the multibeam processable area 114 is such that the third sensor 143 is positioned to measure substantially the same portion of the sample surface that the first sensor 141 was positioned to measure when the multibeam processable area 114 was at the first position. This means that the correction value generated in step S3 will be applicable to obtain from a measurement by the third sensor 143 information (e.g., height) about the sample surface at the center of the multibeam processable area 114 at the second position.

In step S5, a measurement of the sample surface is obtained using the third sensor 143 while the multibeam processable area 114 is at the second position for example on the sample surface.

In step S6, topographical information about a portion of the sample surface processable by the multibeam when the multibeam processable area 114 is at the second position is determined by using the measurement obtained by the third sensor 143 while the multibeam processable area 114 is at the second position and the generated correction value.

In step S7, a position and/or orientation of the sample 208 (e.g., height and/or tilt) is adjusted using the topographical information obtained in step S6.

In step S8, the sample is processed (e.g., assessed such as inspected or measured) using the multibeam while the multibeam processable area 114 is at the second position after the adjustment of step S7.

In some embodiments, as illustrated in **FIG. 20**, the plurality of sensors comprises one or more additional sensors 144, 145, for example the fourth proximal sensor 144 and the fifth proximal sensor 145. (Note the fifth proximal sensor 145 is not the calibration sensor 141 (or the first sensor) which may be referred to as the 'fifth sensor' in the context of being additional to the four proximal sensors 120A-D or 142 to 145). The one or more additional sensors are each positioned such that, in a projection of positions of the sensors 141-145 and the multibeam processable area 114 onto a plane parallel to the sample 208, a vector 155, 156 (or proximal vectors or third and fourth proximal vectors) joining a position of the additional sensor 144, 145 to the center of the multibeam processable area 114 is substantially equal or opposite to the proximal vector 152 (or a first proximal vector) joining the position of the third sensor 143 to the center of the multibeam processable area 114 or a vector 154 (or a second proximal vector) joining the second sensor 142 to the center of the multibeam processable area 114. The first to fourth proximal vectors all have the same length but different directions. The fourth proximal vector 156 may have a direction opposite to that of the first proximal vector 152. The third proximal vector 155 may have a direction opposite to that of the second proximal vector 154. The first to fourth proximal vectors may have the same length as either of the distal vectors 151, 153 for example a first distal vector 151 and a second distal vector 153. The first distal vector 151 may join the first sensor 141 with the second sensor 142. The second distal vector 153 may join the first sensor 141 with the third sensor 143. The first distal vector 151 may be a translation of the first proximal vector 152, having a common direction and length. The second distal vector 151 may be a translation of the second proximal vector 154, having a common direction and length. These geometrical relationships provide enhanced flexibility for obtaining correction factors that can be used to obtain information about the sample surface at the center of the multibeam processable area 114 using different combinations of the sensors 141-145, e.g the five sensors of for example four proximal sensors and at least one distal sensor. For example, a correction value generated based on the first and second sensors 141, 142 can be used to obtain information about the sample surface at the center of the multibeam processable area 114 using an output from the additional sensor 144. A correction value generated based on the first and third sensors 141, 143 (corresponding to vector 153, e.g. the second distal vector) can be used to obtain information about the sample surface at the center of the multibeam processable area 114 using an output from the second sensor 142 or the additional sensor 145 (because vectors 154 and 155 (e.g. the second proximal vector and the third proximal vector) are equal or opposite to the vector 153 (e.g. the second distal vector)).

The mirror symmetry relative to the horizontal and vertical axes in the plane of the page of the arrangements shown in **FIG. 19** and **20** thus provides advantages. The mirror symmetry is not essential, however. Arranging the sensors 141-145 such that only a single vector 151 between two sensors is equal or opposite to a vector joining a sensor (optionally a different sensor) to the center of the multibeam processable area 114 may be used. Such an arrangement provides the capability of obtaining a correction factor that can be used by that (optionally different) sensor to obtain information about the sample surface at the center of the multibeam processable area 114.

In some embodiments, as exemplified in **FIG. 19** and **20**, the plurality of sensors 141-145 comprises two additional sensors 144, 145 positioned such that, in a projection of positions of the sensors 141-145 and the multibeam processable area 114 onto a plane parallel to the sample 208, the second sensor 142, third sensor 143 and two additional sensors 144, 145 define vertices of a rectangle. As exemplified in **FIG. 19** and **20**, the first sensor 141 may optionally be aligned with a center of the rectangle in a direction parallel to a first side of the rectangle. As exemplified in **FIG. 19** and **20**, the first sensor 141, second sensor 142, third sensor 143 and center of the multibeam processable area 114 may define vertices of a rhombus or even a parallelogram. The first sensor 141 may be positioned more remotely from the paths of the sub-beams than the second sensor 142 and the third sensor 143. A distance between the between the first sensor 141 and the second sensor 142 may be substantially equal to a distance between the first sensor 141 and the third sensor 143.

In an embodiment, the vector 152 joining positions of the second sensor 142 and the center of the multibeam processable area 114 is substantially equal or opposite to the vector 153 joining positions of the third sensor 143 and the first sensor 141. A distance between the first sensor 141 and the third sensor 143 may thus be substantially the same as the distance between of the third sensor 143 and the center of the multibeam path.

The plurality of sensors 141-145 may comprise proximal sensors 120A-D and distal sensors 121-124 in arrangements corresponding to those discussed above with reference to **FIG. 10-17**. For example, proximal and distal sensors may be provided such that at least one distal sensor 121 is positioned such that, in a projection of positions of the sensors and the multibeam processable area 114 onto a plane parallel to the sample 208, a vector joining a position of the distal sensor 121 to a position of one of the proximal sensors 120 is substantially equal or opposite to a vector joining a position of one of the proximal sensors 120 to a center of the multibeam processable area 114. Thus, in this case the distal sensor 121 corresponds to the first sensor 141 in **FIG. 19** and **20**, the proximal sensors 120 correspond to the second sensor 142 and third sensor 143 in **FIG. 19** and **20**. Similarly, at least one distal sensor 121 may be positioned such that the distal sensor 121 and two of the proximal sensors 120 are configured to measure respective portions of the sample surface that, together with a center of the multibeam processing area 114, define vertices of a rhombus or even a parallelogram. In an embodiment, the plurality of sensors 141-145 are configured such that the first sensor 141 is a distal sensor and the second, third, fourth and fifth sensors 142-145 are proximal sensors. In an embodiment, one or more further sensors are provided and configured to operate as distal sensors. Each of the further sensors may be positioned at a respective one of the locations corresponding to the distal sensors 122, 123 and 124 shown in **FIG. 12**. Each distal sensor may have two closest proximal sensors. The distance between the position of the distal sensor and each of the two closest proximal sensors may be the same for each of the distal sensors.

Electron-optics described herein may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). Electron-optical elements may have magnetic elements and electrostatic elements. For example, a compound array lens may feature a macro magnetic lens encompassing the multi-beam path with an upper and lower pole plate within the magnetic lens and arranged along the multi-beam path. In the pole plates may be an array of apertures for the beam paths of the multi-beam. Electrodes may be present above, below or between the pole plates to control and optimize the electromagnetic field of the compound lens array.

An assessment apparatus, tool or system according to the disclosure may comprise apparatus which makes a qualitative assessment of a sample (e.g. pass/fail), one which makes a quantitative measurement (e.g. the size of a feature) of a sample for example a to measure at least part of feature of the sample or one which generates an image of map of a sample. Examples of assessment apparatus, tools or systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools).

Functionality provided by the controller or control system or control unit may be computer-implemented. Any suitable combination of elements may be used to provide the required functionality, including for example CPUs, RAM, SSDs, motherboards, network connections, firmware, software, and/or other elements known in the art that allow the required computing operations to be performed. The required computing operations may be defined by one or more computer programs. The one or more computer programs may be provided in the form of media, optionally non-transitory media, storing computer readable instructions. When the computer readable instructions are read by the computer, the computer performs the required method steps. The computer may consist of a self-contained unit or a distributed computing system having plural different computers connected to each other via a network.

Aspects of the invention are disclosed in the following clauses:

Clause 1. An electron-optical apparatus, comprising: a stage configured to support a sample having a sample surface; a charged particle device configured to project a multibeam towards the sample along a multibeam path that intersects the sample in a multibeam processable area, the multibeam comprising a plurality of sub-beams of charged particles having paths within the multibeam path desirably arranged in a grid; a sensing system comprising: a group of proximal sensors positioned proximate to the paths of the plurality of sub-beams, each proximal sensor configured to measure a position of a respective portion of the sample surface relative to that proximal sensor, and one or more distal sensors, the or each distal sensor positioned more remotely from the paths of the sub-beams than the proximal sensors, the or each distal sensor being configured to measure a position of a respective portion of the sample surface relative to the distal sensor; and a control system configured to: control the charged particle device to process the sample surface in the multibeam processable area using the multibeam, desirably to assess the sample surface using the multibeam; control the stage to cause the multibeam processable area to move along a processing path in a reference frame of the sample; and control the sensing system to use at least the one or more distal sensors to obtain topographical information about the sample surface in a selected portion of the processing path before the multibeam processable area reaches the selected portion of the processing path.

Clause 2. The apparatus of clause 1, wherein the control system is configured to control the sensing system and the charged particle device to respectively obtain topographical information and process the sample surface in different respective portions of the processing path at the same time.

Clause 3. The apparatus of clause 1 or 2, wherein the control system is configured to adjust the position and/or orientation of the sample based on the obtained topographical information about the sample surface in the selected portion when the multibeam processable area reaches the selected portion

Clause 4. The apparatus of any preceding clause, wherein the one or more distal sensors comprises at least one distal sensor positioned ahead of the multibeam processable area along the processing path.

Clause 5. The apparatus of any preceding clause, wherein the processing path comprises a plurality of routes that are parallel and offset with respect to each other in an offset direction across the sample surface and the control system is configured to cause the multibeam processable area to move along the routes in sequence, the control system desirably being configured to displace the multibeam processable area and the routes relative to each other between different routes of the processing path, desirably in the offset direction across the sample surface.

Clause 6. The apparatus of clause 5, wherein the one or more distal sensors comprises at least one distal sensor positioned to measure a portion of the sample surface in the same route as the multibeam processable area, the at least one distal sensor desirably comprising a forward sensor positioned to measure a portion of the sample surface in the same route before the multibeam processable area is moved over that portion of the sample surface.

Clause 7. The apparatus of clause 6, wherein the at least one distal sensor comprises a distal sensor positioned substantially centrally with respect to a dimension of the multibeam processable area perpendicular to relative movement of the multibeam processable area along the route.

Clause 8. The apparatus of clause 6 or 7, wherein the at least one distal sensor comprises a rear sensor and the forward sensor, the rear sensor and the forward sensor being positioned to be capable of simultaneously measuring portions of the sample surface on opposite sides of the multibeam processable area.

Clause 9. The apparatus of any of clauses 5 to 8, wherein the one or more distal sensors comprises a side sensor positioned to measure a portion of the sample surface in one of the routes before the multibeam processable area is moved over that portion of the sample surface and while the multibeam processable area is within a different one of the routes.

Clause 10. The apparatus of clause 9, wherein the side sensor is positioned to measure a portion of the sample surface that is substantially aligned with a center of the multibeam processable area in a direction perpendicular to relative movement of the multibeam processable area along one of the routes.

Clause 11. The apparatus of clause 9 or 10, wherein, the side sensor being a first side sensor, the one or more distal sensors further comprises a second side sensor, the first side sensor and the second side sensor being positioned to be capable of simultaneously measuring portions of the sample surface on opposite sides of the multibeam processable area, desirably within different routes from the route in which the multibeam processable area is located at that time.

Clause 12. The apparatus of any preceding clause, wherein the group of proximal sensors comprise four proximal sensors positioned to measure four respective portions of the sample surface defining vertices of a four-sided shape.

Clause 13. The apparatus of clause 12, wherein the four-sided shape is a rectangle.

Clause 14. The apparatus of clause 13, wherein the one or more distal sensors comprise a first distal sensor positioned to measure a respective portion of the sample surface that is aligned with a center of the rectangle in a direction parallel to a first side of the rectangle.

Clause 15. The apparatus of clause 14, wherein the one or more distal sensors further comprises a second distal sensor positioned to measure a portion of the sample surface that is aligned with the center of the rectangle in a direction parallel to a second side of the rectangle, the second side being orthogonal to the first side.

Clause 16. The apparatus of any of clauses 12 to 15, wherein the one or more distal sensors comprise at least one distal sensor positioned such that the distal sensor and two of the proximal sensors are configured to measure respective portions of the sample surface that, together with a center of the multibeam processing area, define vertices of a rhombus.

Clause 17. The apparatus of any preceding clause, wherein the one or more distal sensors comprise at least one distal sensor positioned such that, in a projection of positions of the sensors and the multibeam processable area onto a plane parallel to the sample, a vector joining a position of the distal sensor to a position of one of the proximal sensors is substantially equal or opposite to a vector joining a position of one of the proximal sensors to a center of the multibeam processable area.

Clause 18. The apparatus of any preceding clause, wherein the proximal sensors and the one or more distal sensors are positioned at substantially the same distance from the stage.

Clause 19. An electron-optical apparatus, comprising: a stage configured to support a sample having a sample surface; a charged particle device configured to project a multibeam towards the sample along a multibeam path that intersects the sample in a multibeam processable area to process the sample with the multibeam, the multibeam comprising a plurality of sub-beams of charged particles having paths within the multibeam path desirably arranged in a grid; and a sensing system comprising a plurality of sensors, each sensor being configured to measure a position relative to the sensor of a respective portion of the sample surface outside of the multibeam processable area, wherein the plurality of sensors comprises at least a first sensor, a second sensor, and a third sensor positioned such that, in a projection of positions of the sensors and the multibeam processable area onto a plane parallel to the sample, a vector joining positions of the first sensor and the second sensor is substantially equal or opposite to a vector joining a position of the third sensor to a center of the multibeam processable area.

Clause 20. The apparatus of clause 19, further comprising a control system configured to determine topographical information about a portion of the sample surface to be processed by the multibeam by: controlling the stage to cause the multibeam processable area to be at a first position on the sample surface; controlling the sensing system to obtain measurements of the sample surface using the first sensor and the second sensor while the multibeam processable area is at the first position; generating a correction value using the measurements obtained by the first sensor and the second sensor while the multibeam processable area is at the first position; controlling the stage to cause the multibeam processable area to move to a second position on the sample surface, the second position desirably being such that the third sensor is positioned to measure substantially the same portion of the sample surface that the first sensor was positioned to measure when the multibeam processable area was at the first position; controlling the sensing system to obtain a measurement of the sample surface using the third sensor while the multibeam processable area is at the second position; and determining topographical information about a portion of the sample surface processable by the multibeam when the multibeam processable area is at the second position by using the measurement obtained by the third sensor while the multibeam processable area is at the second position and the generated correction value.

Clause 21. The apparatus of clause 19 or 20, wherein the plurality of sensors comprises one or more additional sensors that are each positioned such that, in a projection of positions of the sensors and the multibeam processable area onto a plane parallel to the sample, a vector joining a position of the additional sensor to the center of the multibeam path is substantially equal or opposite to: the vector joining the position of the third sensor to the center of the multibeam path; or a vector joining either of the first sensor or the second sensor to the center of the multibeam processable area.

Clause 22. The apparatus of any of clauses 19 to 21, wherein the plurality of sensors comprises two additional sensors positioned such that, in a projection of positions of the sensors and the multibeam processable area onto a plane parallel to the sample, the second sensor, third sensor and two additional sensors define vertices of a rectangle.

Clause 23. The apparatus of clause 22, wherein, in a projection of positions of the sensors and the multibeam processable area onto a plane parallel to the sample, the first sensor is aligned with a center of the rectangle in a direction parallel to a first side of the rectangle.

Clause 24. The apparatus of any of clauses 19 to 23, wherein, in a projection of positions of the sensors and the multibeam processable area onto a plane parallel to the sample, the first sensor, second sensor, third sensor and center of the multibeam processable area define vertices of a rhombus.

Clause 25. The apparatus of any of clauses 19 to 24, wherein the first sensor is positioned more remotely from the paths of the sub-beams than the second sensor and the third sensor.

Clause 26. The apparatus of any of clauses 19 to 25 wherein a distance between the first sensor and the second sensor is substantially equal to a distance between the first sensor and the third sensor.

Clause 27. The apparatus of any of clauses 19 to 26, wherein, in a projection of positions of the sensors and the multibeam processable area onto a plane parallel to the sample, a vector joining positions of the second sensor and the center of the multibeam processable area is substantially equal or opposite to a vector joining positions of the third sensor and the first sensor.

Clause 28. The apparatus of any of clauses 19 to 27, wherein a distance between the first sensor and the third sensor is substantially the same as the distance between the third sensor and the center of the multibeam path.

Clause 29. The apparatus of any of clauses 19 to 28, wherein the second and third sensors and desirably, where provided at least one of the additional sensors, are proximal sensors, and the first sensor and desirably at least one further sensor are distal sensors, desirably the first sensor being a calibration sensor, desirably each distal sensor having two closest proximal sensors and the distance between the position of the distal sensor and each of the two closest proximal sensors is the same.

Clause 30. The apparatus of clause 1, wherein the one or more distal sensors comprises at least one distal sensor positioned away from the grid along the processing path.

Clause 31. The apparatus of clause 1 or 30, wherein the one or more distal sensors comprises a side sensor positioned away from the grid in a direction orthogonal to the processing path, desirably at a different side of the grid from a forward or rear sensor.

Clause 32. The apparatus of clause 1, 30 or 31, wherein, the side sensor being a first side sensor, the one or more distal sensors further comprises a second side sensor positioned on an opposite side of the grid from the first side sensor.

Clause 33. The apparatus of any of clauses 1 and 30 to 32, wherein the at least one or each distal sensor is positioned substantially centrally with respect to a dimension of the grid proximate the sample surface orthogonal to the multi-beam path.

Clause 34. The apparatus of any of clauses 1 and 30 to 33, wherein the control system is configured to displace the sample and the grid relative to each other between different routes of the processing path across the sample surface, desirably the routes are parallel and offset with respect to each other, desirably the control system is configured to move the sample and the grid relative to each other between routes desirably in sequence.

Clause 35. The apparatus of clause 34, wherein the one or more distal sensors comprises at least one distal sensor positioned relative to the grid and the processing path to measure a portion of the sample surface in the same route.

Clause 36. The apparatus of clause 35, wherein the at least one distal sensor comprises at least one of a forward and rear sensor configured to measure a portion of the sample surface displaced from the grid along the route.

Clause 37. The apparatus of any of clauses 34 to 36 when dependent on clause 31, wherein the side sensor is positioned to measure a portion of the sample surface in a different route from of the route in the multibeam path.

Clause 38. The apparatus of clause 37, wherein the side sensor is positioned to measure a portion of the sample surface displaced in a direction perpendicular to relative movement between the sample surface and the grid along a different route from the route in the multibeam path.

Clause 39. The apparatus of any of clauses 1 to 18 and 30 to 38, wherein the group of proximal sensors comprise four proximal sensors positioned such that the four proximal sensors define respective vertices of a four sided shape centered on a center of the multibeam, the four sided shape desirably being a rectangle.

Clause 40. The apparatus of any of clauses 1 to 18 and 30 to 39, wherein the apparatus is configured to use the obtained topographical information to position the sample on the fly and/or to adjust a position and/or orientation of the stage when the multibeam volume reaches the selected portion of the processing path.

Clause 41. A method of obtaining topographical information about a sample surface, comprising: projecting a multi-beam of charged particles towards a sample along a multibeam path that intersects the sample in a multibeam processable area to process the sample surface in the multibeam processable area, the multibeam comprising a plurality of sub-beams having paths within the multibeam path desirably arranged in a grid; using a group of proximal sensors positioned proximate to the paths of the plurality of sub-beams to measure positions of respective portions of the sample surface relative to the proximal sensors; using one or more distal sensors positioned more remotely from the paths of the sub-beams than the proximal sensors to measure one or more respective portions of the sample surface relative to the one or more distal sensors; providing relative movement between the multibeam processable area and the sample such that the multibeam processable area moves along a processing path in a reference frame of the sample; and using at least the one or more distal sensors to obtain topographical information about the sample surface in a selected portion of the processing path before the multibeam processable area reaches the selected portion of the processing path.

Clause 42. The method of clause 41, comprising obtaining topographical information in one portion of the processing path while processing the sample surface using the multibeam in another portion of the processing path.

Clause 43. The method of clause 41 or 42, further comprising controlling the position and/or orientation of the sample based on the obtained topographical information about the sample surface in the selected portion of the processing path when the multibeam processable area reaches that selected portion.

Clause 44. The method of any of clauses 41 to 43, wherein the one or more distal sensors comprises at least one distal sensor positioned ahead of the multibeam processable area along the processing path.

Clause 45. The method of clause 44, wherein the processing path comprises a plurality of routes that are parallel and offset with respect to each other in an offset direction across the sample surface and the providing of relative movement comprises moving the multibeam processable area along the routes in sequence, desirably displacing the multibeam processable area and the routes relative to each other between different routes of the processing path, desirably in the offset direction across the sample surface.

Clause 46. The method of any of clauses 41 to 45, wherein the one or more distal sensors comprises at least one distal sensor that measures a portion of the sample surface in the same route as the multibeam processable area, desirably as a forward sensor measuring the portion of the sample surface in the same route before the multibeam processable area moves over that portion of the sample surface.

Clause 47. The method of clause 46, wherein the at least one distal sensor comprises a distal sensor positioned substantially centrally with respect to a dimension of the multibeam processable area perpendicular to relative movement of the multibeam processable area along the route.

Clause 48. The method of clause 46 or 47, wherein the at least one distal sensor comprises a rear sensor and the forward sensor, the rear sensor and the forward sensor being used to simultaneously measure portions of the sample surface on opposite sides of the multibeam processable area.

Clause 49. The method of any of clauses 45 to 48, wherein the one or more distal sensors comprises a side sensor that measures a portion of the sample surface in one of the routes before the multibeam processable area is moved over that portion of the sample surface and while the multibeam processable area is within a different one of the routes.

Clause 50. The method of clause 49, wherein the side sensor measures a portion of the sample surface that is substantially aligned with a center of the multibeam processable area in a direction perpendicular to relative movement of the multibeam processable area along one of the routes.

Clause 51. The method of clause 50, wherein, the side sensor being a first side sensor, the one or more distal sensors further comprises a second side sensor, the first side sensor and the second side sensor being capable of simultaneously measuring portions of the sample surface on opposite sides of the multibeam processable area, desirably within different routes from the route in which the multibeam processable area is located at that time.

Clause 52. The method of any of clauses 41 to 51, wherein the group of proximal sensors comprise four proximal sensors positioned to measure four respective portions of the sample surface defining vertices of a four-sided shape.

Clause 53. The method of clause 52, wherein the four-sided shape is a rectangle.

Clause 54. The method of clause 53, wherein the one or more distal sensors comprise a first distal sensor that measures a respective portion of the sample surface that is aligned with a center of the rectangle in a direction parallel to a first side of the rectangle.

Clause 55. The method of clause 54, wherein the one or more distal sensors further comprises a second distal sensor that measures a portion of the sample surface that is aligned with the center of the rectangle in a direction parallel to a second side of the rectangle, the second side being orthogonal to the first side.

Clause 56. The method of any of clauses 52 to 55, wherein the one or more distal sensors comprise at least one distal sensor positioned such that the distal sensor and two of the proximal sensors measure respective portions of the sample surface that, together with a center of the multibeam processable area, define vertices of a rhombus.

Clause 57. The method of any of clauses 42 to 56, wherein the one or more distal sensors comprise at least one distal sensor positioned such that, in a projection of positions of the sensors and the multibeam processable area onto a plane parallel to the sample, a vector joining a position of the distal sensor to a position of one of the proximal sensors is substantially equal or opposite to a vector joining a position of one of the proximal sensors to a center of the multibeam processable area.

Clause 58. The method of any of clauses 42 to 57, wherein the proximal sensors and the one or more distal sensors are positioned at substantially the same distance from the stage.

Clause 59. A method of obtaining topographical information about a sample surface, comprising: projecting a multibeam of charged particles towards the sample along a multibeam path that intersects the sample in a multibeam processable area to process the sample with the multibeam, the multibeam comprising a plurality of sub-beams having paths within the multibeam path desirably arranged in a grid; obtaining topographical information about the sample surface using a plurality of sensors to measure positions relative to the sensors of respective portions of the sample surface outside of the multibeam processable area, wherein the plurality of sensors comprises at least a first sensor, a second sensor, and a third sensor positioned such that, in a projection of positions of the sensors and the multibeam processable area onto a plane parallel to the sample, a vector joining positions of the first sensor and the second sensor is substantially equal or opposite to a vector joining a position of the third sensor to a center of the multibeam processable area.

Clause 60. The method of clause 59, wherein the obtaining of topographical information comprises: positioning the multibeam processable area at a first position on the sample surface; obtaining measurements of the sample surface using the first sensor and the second sensor while the multibeam processable area is at the first position; generating a correction value using the measurements obtained by the first sensor and the second sensor while the multibeam processable area is at the first position; moving the multibeam processable area to a second position on the sample surface, the second position desirably being such that the third sensor is positioned to measure substantially the same portion of the sample surface that the first sensor was positioned to measure when the multibeam processable area was at the first position; obtaining a measurement of the sample surface using the third sensor while the multibeam processable area is at the second position; and determining topographical information about a portion of the sample surface processable by the multibeam when the multibeam processable area is at the second position by using the measurement obtained by the third sensor while the multibeam processable area is at the second position and the generated correction value.

Clause 61. The method of clause 59 or 60, wherein the plurality of sensors comprises one or more additional sensors that are each positioned such that, in a projection of positions of the sensors and the multibeam processable area onto a plane parallel to the sample, a vector joining a position of the additional sensor to the center of the multibeam processable area is substantially equal or opposite to: the vector joining the position of the third sensor to the center of the multibeam processable area; or a vector joining either of the first sensor or the second sensor to the center of the multibeam path.

Clause 62. The method of any of clauses 59 to 61, wherein the plurality of sensors comprise two additional sensors positioned such that, in a projection of positions of the sensors and the multibeam processable area onto a plane parallel to the sample, the second sensor, third sensor and two additional sensors define vertices of a rectangle.

Clause 63. The method of clause 62, wherein, in a projection of positions of the sensors and the multibeam processable area onto a plane parallel to the sample, the first sensor is aligned with a center of the rectangle in a direction parallel to a first side of the rectangle.

Clause 64. The method of any of clauses 59 to 63, wherein, in a projection of positions of the sensors and the multibeam processable area onto a plane parallel to the sample, the first sensor, second sensor, third sensor and center of the multibeam processable area define vertices of a rhombus.

Clause 65. The method of any of clauses 59 to 64, wherein the first sensor is positioned more remotely from the paths of the sub-beams than the second sensor and the third sensor.

Clause 66. The method of any of clauses 59 to 65, wherein a distance between the first sensor and the second sensor is substantially equal to a distance between the first sensor and the third sensor.

Clause 67. A computer program comprising instructions interpretable by a computer that controls an assessment apparatus, the computer program comprising instructions to perform a method according any of clauses 41 to 66.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

**Claims**

1. A method of obtaining topographical information about a sample surface, comprising:

   projecting a multibeam of charged particles towards a sample along a multibeam path that intersects the sample in a multibeam processable area to process the sample surface in the multibeam processable area, the multibeam comprising a plurality of sub-beams having paths within the multibeam path desirably arranged in a grid;
   using a group of proximal sensors positioned proximate to the paths of the plurality of sub-beams to measure positions of respective portions of the sample surface relative to the proximal sensors;
   using one or more distal sensors positioned more remotely from the paths of the sub-beams than the proximal sensors to measure one or more respective portions of the sample surface relative to the one or more distal sensors;
   providing relative movement between the multibeam processable area and the sample such that the multibeam processable area moves along a processing path in a reference frame of the sample; and
   using at least the one or more distal sensors to obtain topographical information about the sample surface in a selected portion of the processing path before the multibeam processable area reaches the selected portion of the processing path.

2. The method of claim 1, comprising obtaining topographical information in one portion of the processing path while processing the sample surface using the multibeam in another portion of the processing path.

3. The method of claim 1 or 2, further comprising controlling the position and/or orientation of the sample based on the obtained topographical information about the sample surface in the selected portion of the processing path when the multibeam processable area reaches that selected portion.

4. The method of any of claims 1 to 3, wherein the one or more distal sensors comprises at least one distal sensor positioned ahead of the multibeam processable area along the processing path, desirably wherein the processing path comprises a plurality of routes that are parallel and offset with respect to each other in an offset direction across the sample surface and the providing of relative movement comprises moving the multibeam processable area along the routes in sequence, desirably displacing the multibeam processable area and the routes relative to each other between different routes of the processing path, desirably in the offset direction across the sample surface.

5. The method of any of claims 1 to 4, wherein the one or more distal sensors comprises at least one distal sensor that measures a portion of the sample surface in the same route as the multibeam processable area, desirably as a forward sensor measuring the portion of the sample surface in the same route before the multibeam processable area moves over that portion of the sample surface.

6. The method of claim 5, wherein the at least one distal sensor comprises a distal sensor positioned substantially centrally with respect to a dimension of the multibeam processable area perpendicular to relative movement of the multibeam processable area along the route.

7. The method of claim 5 or 6, wherein the at least one distal sensor comprises a rear sensor and the forward sensor, the rear sensor and the forward sensor being used to simultaneously measure portions of the sample surface on opposite sides of the multibeam processable area.

8. The method of any of claims 5 to 7, wherein the one or more distal sensors comprises a side sensor that measures a portion of the sample surface in one of the routes before the multibeam processable area is moved over that portion of the sample surface and while the multibeam processable area is within a different one of the routes.

9. The method of any of claims 1 to 8, wherein the group of proximal sensors comprise four proximal sensors positioned to measure four respective portions of the sample surface defining vertices of a four-sided shape.

10. The method of claim 9, wherein the four-sided shape is a rectangle and
the one or more distal sensors comprise a first distal sensor that measures a respective portion of the sample surface that is aligned with a center of the rectangle in a direction parallel to a first side of the rectangle.

11. The method of claim 10, wherein the one or more distal sensors further comprises a second distal sensor that measures a portion of the sample surface that is aligned with the center of the rectangle in a direction parallel to a second side of the rectangle, the second side being orthogonal to the first side.

12. The method of any of claims 9 to 11, wherein the one or more distal sensors comprise at least one distal sensor positioned such that the distal sensor and two of the proximal sensors measure respective portions of the sample surface that, together with a center of the multibeam processable area, define vertices of a rhombus.

13. The method of any of claims 2 to 12, wherein the one or more distal sensors comprise at least one distal sensor positioned such that, in a projection of positions of the sensors and the multibeam processable area onto a plane parallel to the sample, a vector joining a position of the distal sensor to a position of one of the proximal sensors is substantially equal or opposite to a vector joining a position of one of the proximal sensors to a center of the multibeam processable area.

14. The method of any of claims 2 to 13, wherein the proximal sensors and the one or more distal sensors are positioned at substantially the same distance from the stage.

15. An electron-optical apparatus, comprising:

a stage configured to support a sample having a sample surface;
a charged particle device configured to project a multibeam towards the sample along a multibeam path that intersects the sample in a multibeam processable area, the multibeam comprising a plurality of sub-beams of charged particles having paths within the multibeam path desirably arranged in a grid;
a sensing system comprising:

a group of proximal sensors positioned proximate to the paths of the plurality of sub-beams, each proximal sensor configured to measure a position of a respective portion of the sample surface relative to that proximal sensor, and
one or more distal sensors, the or each distal sensor positioned more remotely from the paths of the sub-beams than the proximal sensors, the or each distal sensor being configured to measure a position of a respective portion of the sample surface relative to the distal sensor; and

a control system configured to:

control the charged particle device to process the sample surface in the multibeam processable area using the multibeam, desirably to assess the sample surface using the multibeam;
control the stage to cause the multibeam processable area to move along a processing path in a reference frame of the sample; and
control the sensing system to use at least the one or more distal sensors to obtain topographical information about the sample surface in a selected portion of the processing path before the multibeam processable area reaches the selected portion of the processing path.

# Fig. 1

# Fig. 2

40

201

202

230

240

211, 212, 213

221, 222, 223

208

207

209

# Fig. 3

# Fig. 4

100μm    50μm

5kV

few kV

401

5kV– 10 to 100V

402

208

5kV

406

# Fig. 5

402

404

405

406

# Fig. 6

406

# Fig. 7

# Fig. 8

# Fig. 9

# Fig. 10

# Fig. 11

# Fig. 12

# Fig. 13

# Fig. 14

Fig. 15

Fig. 16

# Fig. 17

# Fig. 18

# Fig. 19

# Fig. 20

# Fig. 21

Europäisches
Patentamt

European
Patent Office

Office européen
des brevets

# EUROPEAN SEARCH REPORT

Application Number

EP 22 18 6294

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2007/035714 A1 (GALBURT DANIEL N [US]) 15 February 2007 (2007-02-15) * paragraphs [0008], [0012], [0070] – [0073]; figures 2,3 * | 1-15 | INV. H01J37/317 H01J37/28 H01J37/26 H01J37/21 G03F9/00 |
| Y | WO 2013/132081 A2 (MAPPER LITHOGRAPHY IP BV [NL]) 12 September 2013 (2013-09-12) * paragraphs [0050], [0053], [0017], [0074] * | 1-15 | |

TECHNICAL FIELDS
SEARCHED        (IPC)

H01J
G03F

The present search report has been drawn up for all claims

| Place of search | Date of completion of the search | Examiner |
|---|---|---|
| Munich | 4 January 2023 | Oestreich, Sebastian |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
...........................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 22 18 6294

This annex lists the patent family members relating to the patent documents cited in the above-mentioned European search report.
The members are as contained in the European Patent Office EDP file on
The European Patent Office is in no way liable for these particulars which are merely given for the purpose of information.

04-01-2023

| Patent document cited in search report | | Publication date | Patent family member(s) | | Publication date |
|---|---|---|---|---|---|
| US 2007035714 | A1 | 15-02-2007 | JP 2007049165 | A | 22-02-2007 |
| | | | US 2007035714 | A1 | 15-02-2007 |
| WO 2013132081 | A2 | 12-09-2013 | CN 104272194 | A | 07-01-2015 |
| | | | EP 2823361 | A2 | 14-01-2015 |
| | | | JP 6219320 | B2 | 25-10-2017 |
| | | | JP 2015513219 | A | 30-04-2015 |
| | | | NL 2010415 | C2 | 31-12-2013 |
| | | | TW 201346984 | A | 16-11-2013 |
| | | | US RE49241 | E | 11-10-2022 |
| | | | US 2015109598 | A1 | 23-04-2015 |
| | | | WO 2013132081 | A2 | 12-09-2013 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1602121 A1
- EP 20184160
- US 20110193574 A